# EUROPEAN PATENT APPLICATION

(11) **EP 4 793 989 A1**
(43) Date of publication of application: **19.08.2026**
(21) Application number: 24877238.6
(22) Date of filing: 10.10.2024
(51) Int. Cl.: H01L 21/306, H01L 21/304

(54) **SUBSTRATE PROCESSING DEVICE, SUBSTRATE PROCESSING METHOD, AND SUBSTRATE PROCESSING PROGRAM**

(30) Priority: 12.10.2023 JP 2023177110; 03.10.2024 JP 2024174558
(71) Applicant: SCREEN Holdings Co., Ltd., Kyoto-shi, Kyoto 602-8585 (JP)
(72) Inventor: ENDO, Toru, Kyoto-shi, Kyoto 602-8585 (JP); KATO, Takuji, Kyoto-shi, Kyoto 602-8585 (JP); AOKI, Rikuta, Kyoto-shi, Kyoto 602-8585 (JP); KIKUCHI, Shunki, Kyoto-shi, Kyoto 602-8585 (JP); YAMANOUCHI, Yuta, Kyoto-shi, Kyoto 602-8585 (JP); ODANI, Kaito, Kyoto-shi, Kyoto 602-8585 (JP); IKEGAMI, Yutaka, Kyoto-shi, Kyoto 602-8585 (JP)
(74) Representative: Kilian Kilian & Partner mbB
(86) International application number: PCT/JP2024/036298
(87) International publication number: WO 2025/079644

(57) **Abstract**

A substrate processing apparatus that processes a film by supplying a processing liquid to a substrate on which the film is formed includes a rotation driver that rotates the substrate while holding the substrate, a discharger that discharges the processing liquid, a processing liquid supplier that supplies the processing liquid to the discharger, a discharge driver that moves the discharger to positions above a plurality of different positions on the substrate held by the rotation driver, the plurality of different positions being arranged in a radial direction of the substrate, and a controller that controls the processing liquid supplier and the discharge driver in accordance with a processing condition, wherein the processing condition includes a moving condition that defines a moving speed of the discharger for each of the plurality of positions, and a flow-rate condition that defines, for each of the plurality of positions, a flow rate of the processing liquid supplied to the discharger.

## Description

### [Technical Field]

The present invention relates to a substrate processing apparatus, a substrate processing method executed by the substrate processing apparatus, and a substrate processing program that causes a computer to execute the substrate processing method.

### [Background Art]

In an etching process of processing a film formed on a substrate, the technique for making the thickness of the processed film uniform is known. For example, Patent Document 1 describes a substrate processing apparatus that includes a rotation holder that holds and rotates a substrate, a processing liquid supplier including a nozzle for discharging a processing liquid to an obverse surface of the substrate, a nozzle driver that moves the nozzle in a direction intersecting with a rotational center of the substrate, and a control device that controls the nozzle driver such that movement of an arrival position of the processing liquid to a position close to an outer periphery of the substrate from a position closer to the rotational center of the substrate in accordance with a first speed profile that changes according to a distance from the rotational center of the substrate, and movement of the arrival position of the processing liquid to a position closer to the rotational center of the substrate from a position close to the outer periphery of the substrate according to a second speed profile different from the first speed profile are repeated.

### [Patent Document 1] JP 2019-54104 A

### [Summary of Invention]

### [Technical Problem]

According to Patent Document 1, a flow rate of the processing liquid discharged from the nozzle is constant. Therefore, the processing liquid that has been supplied to the peripheral portion of the substrate may splash outwardly of the substrate, and the processing liquid may be consumed wastefully. Further, in recent years, it is desired to reduce the consumption of the processing liquid supplied to the substrate from the viewpoint of environmental protection.

An object of the present invention is to provide a substrate processing apparatus capable of reducing consumption of a processing liquid.

### [Solution to Problem]

A substrate processing apparatus according to one aspect of the present invention that processes a film by supplying a processing liquid to a substrate on which the film is formed, includes a rotation driver that rotates the substrate while holding the substrate, a discharger that discharges the processing liquid, a processing liquid supplier that supplies the processing liquid to the discharger, a discharge driver that moves the discharger to positions above a plurality of different positions on the substrate held by the rotation driver, the plurality of different positions being arranged in a radial direction of the substrate, and a controller that controls the processing liquid supplier and the discharge driver in accordance with a processing condition, wherein the processing condition includes a moving condition that defines a moving speed of the discharger for each of the plurality of positions, and a flow-rate condition that defines, for each of the plurality of positions, a flow rate of the processing liquid supplied to the discharger.

A substrate processing apparatus according to another aspect of the present invention includes a rotation driver that rotates a substrate while holding the substrate, a discharger that discharges a processing liquid, a processing liquid supplier that supplies the processing liquid to the discharger, and a discharge driver that moves the discharger to positions above a plurality of different positions on the substrate held by the rotation driver, the plurality of different positions being arranged in a radial direction of the substrate, wherein the processing liquid supplier causes a flow rate of the processing liquid in a case in which the discharger is located above a peripheral area located within a predetermined distance from a periphery of the substrate to be lower than a flow rate of the processing liquid in a case in which the discharger is located above an area other than the peripheral area.

A substrate processing method according to another aspect of the present invention is executed by a substrate processing apparatus, with the substrate processing apparatus processing a film by supplying a processing liquid to a substrate on which the film is formed, wherein the substrate processing apparatus includes a rotation driver that rotates the substrate while holding the substrate, and a discharger that discharges the processing liquid, and the substrate processing method includes a processing liquid supply step of supplying the processing liquid to the discharger in accordance with a moving condition defining a moving speed of the discharger for each of the plurality of positions, and a discharge driving step of moving, in accordance with a flow-rate condition defining a flow rate of the processing liquid supplied to the discharger for each of the plurality of positions, the discharger to positions above a plurality of different positions on the substrate held by the rotation driver, with the plurality of different positions being arranged in a radial direction of the substrate.

A substrate processing method according to another aspect of the present invention is executed by a substrate processing apparatus, with the substrate processing apparatus processing a film by supplying a processing liquid to a substrate on which the film is formed, wherein the substrate processing apparatus includes a rotation driver that rotates the substrate while rotating the substrate, and a discharger that discharges the processing liquid, the substrate processing method includes a processing liquid supply step of supplying the processing liquid to the discharger, a discharge driving step of moving the discharger to positions above a plurality of different positions on the substrate held by the rotation driver, with the plurality of different positions being arranged in a radial direction of the substrate, and the processing liquid supply step includes causing a flow rate of the processing liquid in a case in which the discharger is located above a peripheral area located within a predetermined distance from a periphery of the substrate to be lower than a flow rate of the processing liquid in a case in which the discharger is located above an area other than the peripheral area.

A substrate processing program according to another aspect of the present invention is executed by a computer that controls a substrate processing apparatus, with the substrate processing apparatus processing a film by supplying a processing liquid to a substrate on which the film is formed, wherein the substrate processing apparatus includes a rotation driver that rotates the substrate while rotating the substrate, and a discharger that discharges the processing liquid, and the substrate processing program causes the computer to execute a processing liquid supply step of supplying the processing liquid to the discharger in accordance with a moving condition defining a moving speed of the discharger for each of the plurality of positions, and a discharge driving step of moving, in accordance with a flow-rate condition defining a flow rate of the processing liquid supplied to the discharger for each of the plurality of positions, the discharger to positions above a plurality of different positions on the substrate held by the rotation driver, with the plurality of different positions being arranged in a radial direction of the substrate.

A substrate processing program according to another aspect of the present invention is executed by a computer that controls a substrate processing apparatus, with the substrate processing apparatus processing a film by supplying a processing liquid to a substrate on which the film is formed, wherein the substrate processing apparatus includes a rotation driver that rotates the substrate while holding the substrate, and a discharger that discharges the processing liquid, the substrate processing program causes the computer to execute a processing liquid supply step of supplying the processing liquid to the discharger, and a discharge driving step of moving the discharger to positions above a plurality of different positions on the substrate held by the rotation driver, with the plurality of different positions being arranged in a radial direction of the substrate, and the processing liquid supply step includes causing a flow rate of the processing liquid in a case in which the discharger is located above a peripheral area located within a predetermined distance from a periphery of the substrate to be lower than a flow rate of the processing liquid in a case in which the discharger is located above an area other than the peripheral area.

### [Advantageous Effects of Invention]

With the present invention, it is possible to provide the substrate processing apparatus, the substrate processing method, and the substrate processing program, all of which enable reduction of consumption of the processing liquid.

### [Brief Description of the Drawings]

[FIG. 1] Fig. 1 is a diagram for explaining the configuration of a substrate processing apparatus according to one embodiment of the present invention.
[FIG. 2] Fig. 2 is a diagram for explaining a film process.
[FIG. 3] Fig. 3 is a diagram for explaining a change of a relative position of a nozzle with respect to a substrate.
[FIG. 4] Fig. 4 is a diagram for explaining divided areas.
[FIG. 5] Fig. 5 is a diagram showing one example of a moving speed of the nozzle of a moving condition.
[FIG. 6] Fig. 6 is a diagram showing one example of a flow-rate condition.
[FIG. 7] Fig. 7 is a diagram showing one example of the configuration of a control device.
[FIG. 8] Fig. 8 is a block diagram showing one example of the functional configuration of the control device.
[FIG. 9] Fig. 9 is a flowchart showing a flow of the film process.
[FIG. 10] Fig. 10 is a block diagram of a control device according to a first modified example.
[FIG. 11] Fig. 11 is a diagram showing one example of a rotation condition in the first modified example.
[FIG. 12] Fig. 12 is a flowchart showing one example of a flow of a film process in the first modified example.
[FIG. 13] Fig. 13 is a diagram showing one example of the configuration of a processing liquid supplier in a second modified example.
[FIG. 14] Fig. 14 is a block diagram showing one example of the functions of a control device according to the second modified example.
[FIG. 15] Fig. 15 is a diagram showing one example of a processing condition in the fifth modified example.
[FIG. 16] Fig. 16 is a flowchart showing one example of a flow of a film process in the second modified example.
[FIG. 17] Fig. 17 is a block diagram showing one example of the functions of a control device according to a third modified example.
[FIG. 18] Fig. 18 is a diagram showing one example of a processing condition in the third modified example.
[FIG. 19] Fig. 19 is a flowchart showing one example of a flow of a film process in the third modified example.
[FIG. 20] Fig. 20 is a diagram showing one example of the configuration of a processing liquid supplier included in a substrate processing apparatus in a fourth modified example.
[FIG. 21] Fig. 21 is a block diagram showing one example of the functions of a control device according to the fourth modified example.
[FIG. 22] Fig. 22 is a flowchart showing one example of a flow of a film process in the fourth modified example.
[FIG. 23] Fig. 23 is a diagram showing one example of the configuration of a processing liquid supplier included in a substrate processing apparatus in a fifth modified example.
[FIG. 24] Fig. 24 is a block diagram showing one example of the functions of a control device according to the fifth modified example.
[FIG. 25] Fig. 25 is a diagram showing one example of a processing condition in the fifth modified example.
[FIG. 26] Fig. 26 is a flowchart showing one example of a flow of a film process in the fifth modified example.
[FIG. 27] Fig. 27 is a diagram showing one example of a learning model.
[FIG. 28] Fig. 28 is a block diagram showing one example of the functional configuration of a control device in a second embodiment.
[FIG. 29] Fig. 29 is a flowchart showing a flow of a film process in the second embodiment.

### [Description of Embodiments]

### <First Embodiment>

### (1) Outline of Substrate Processing Apparatus

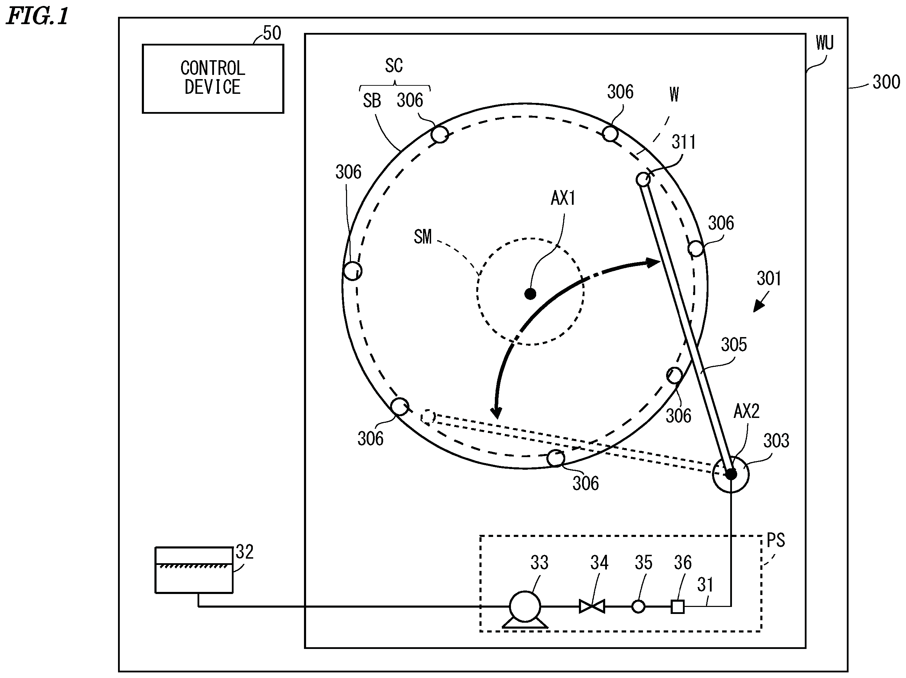

Fig. 1 is a diagram for explaining the configuration of a substrate processing apparatus according to one embodiment of the present invention. The substrate processing apparatus 300 includes a control device 50, a substrate processing unit WU, and a storage tank 32. The control device 50 controls the substrate processing unit WU.

The control device 50 includes a central processing unit (CPU) and a memory, and controls the substrate processing apparatus 300 as a whole by execution, by the CPU, of a program stored in the memory.

The substrate processing unit WU is controlled by the control device 50 and executes a film process of etching a film formed on a substrate W. The substrate processing unit WU includes a spin chuck SC, a spin motor SM, a nozzle 311, and a nozzle moving mechanism 301. The spin chuck SC includes a disc-shaped spin base SB held in a horizontal posture and a plurality of chuck pins 306 that can hold the substrate W in a horizontal posture above the spin base SB. Thus, the spin chuck SC horizontally holds the substrate W. The substrate W is held by the spin chuck SC. The spin motor SM has a first rotation axis AX1. The first rotation axis AX1 extends in an upward-and-downward direction. The spin chuck SC is attached to the upper end portion of the first rotation axis AX1 of the spin motor SM. The first rotation axis AX1 of the spin motor SM coincides with the center of the substrate W. The spin motor SM is a stepping motor. In the present embodiment, the spin motor SM rotates at a constant rotation speed (rpm). When the spin motor SM rotates, the spin chuck SC rotates about the first rotation axis AX1. This causes the substrate W held by the spin chuck SC to rotate about the first rotation axis AX1 at the constant rotation speed. Thus, the rotation speed of the stepping motor and the rotation speed of the substrate W coincide with each other.

The processing liquid supplier PS is controlled by the control device 50, and supplies a processing liquid to the nozzle 311 at a desired flow rate. Specifically, the processing liquid supplier PS includes a supply pipe 31, a supply pump 33, an open-close valve 34, a flow-rate adjustment valve 35, and a flow-rate sensor 36. One end of the supply pipe 31 is connected to the storage tank 32, and the other end of the supply pipe 31 is connected to the nozzle 311. The supply pump 33, the open-close valve 34, the flow-rate adjustment valve 35, and the flow-rate sensor 36 are provided in the supply pipe 31. In the present embodiment, the storage tank 32 is connected to a processing liquid supply source (not shown) outside of the substrate processing apparatus 300, and stores the processing liquid supplied from the processing liquid supply source. Note that the storage tank 32 may be disposed in another casing different from the substrate processing apparatus 300 accommodating the substrate processing unit WU. The supply pump 33 guides the processing liquid stored in the storage tank 32 to the supply pipe 31. The open-close valve 34 is a ball valve, for example, and is switchable between a state in which the processing liquid in the supply pipe 31 is guided to the flow path of the nozzle arm 305 and a state in which the processing liquid in the supply pipe 31 is not guided to the flow path of the nozzle arm 305. The flow-rate adjustment valve 35 can adjust the flow rate of the processing liquid guided to the flow path of the nozzle arm 305 by adjusting the flow rate of the processing liquid in the supply pipe 31. The flow-rate sensor 36 measures the flow rate of the processing liquid in the supply pipe 31. The control device 50 controls the supply pump 33, the open-close valve 34, the flow-rate adjustment valve 35, and the flow-rate sensor 36, all of which are provided in the supply pipe 31. Thus, the processing liquid can be supplied to the substrate processing unit WU. Further, the feedback control is executed on the flow-rate adjustment valve 35 based on the flow rate in the supply pipe 31 measured by the flow-rate sensor 36, so that the processing liquid can be supplied to the substrate processing unit WU at the desired flow rate. Note that the processing liquid supplier PS is not limited to have the above-mentioned configuration. The processing liquid supplier PS does not have to include some of the above-mentioned devices and may include another device.

The nozzle moving mechanism 301 moves the nozzle 311 in a horizontal direction. Specifically, the nozzle moving mechanism 301 has a nozzle motor 303 and a nozzle arm 305. The nozzle motor 303 rotates about a second rotation axis AX2. The nozzle arm 305 has a longitudinal shape extending linearly. One end of the nozzle arm 305 is attached to the upper end of the second rotation axis AX2. The nozzle 311 is attached to the other end of the nozzle arm 305. A flow path (not shown) is formed in the nozzle arm 305. The nozzle 311 has a discharge port (not shown) through which the processing liquid is discharged, and the discharge port is directed downwardly. The flow path of the nozzle arm 305 is connected to the discharge port of the nozzle 311.

The nozzle 311 discharges the processing liquid to an obverse surface (upper surface) of the substrate W held by the spin chuck SC. The processing liquid is supplied from the processing liquid supplier PS to the nozzle 311. The nozzle 311 discharges the processing liquid from the discharge port toward the obverse surface of the rotating substrate W. The flow rate (ml/min) of the processing liquid supplied from the processing liquid supplier PS to the nozzle 311 is equal to the flow rate of the processing liquid discharged from the discharge port of the nozzle 311 toward the obverse surface of the rotating substrate W.

The nozzle motor 303 is a pulse motor, for example. By measuring a pulse provided to the nozzle motor 303, the position of the nozzle 311 can be detected in real time. When the nozzle motor 303 works, the nozzle arm 305 rotates about the second rotation axis AX2 in a horizontal plane. Thus, the nozzle 311 attached to the other end of the nozzle arm 305 moves (pivots) in the horizontal direction about the second rotation axis AX2 at a predetermined speed (mm/sec). The nozzle 311 discharges the processing liquid toward the substrate W from the discharge port while moving in the horizontal direction.

The substrate processing unit WU processes a film formed on the substrate W by supplying the processing liquid to the substrate W on which the film is formed. In the film process, the film is etched. The processing liquid is an etching liquid. The substrate processing unit WU executes the etching process on the film formed on the substrate W by supplying the processing liquid to the substrate W. In the present embodiment, the etching process is executed on a titanium nitride film formed on the substrate W. The etching liquid is a fluoronitric acid (a liquid mixture of hydrofluoric acid (HF) and nitric acid (HNO3)), hydrofluoric acid, buffered hydrofluoric acid (BHF), ammonium fluoride, HFEG (a liquid mixture of hydrofluoric acid and ethylene glycol), or phosphoric acid (H3PO4), for example. While the substrate W to be processed has a diameter of 300 mm in the present embodiment, the present invention is not limited to this. The substrate processing unit WU includes a processing cup (not shown) surrounding the spin chuck SC. The processing cup receives the splashing processing liquid when the substrate W is processed by the processing liquid.

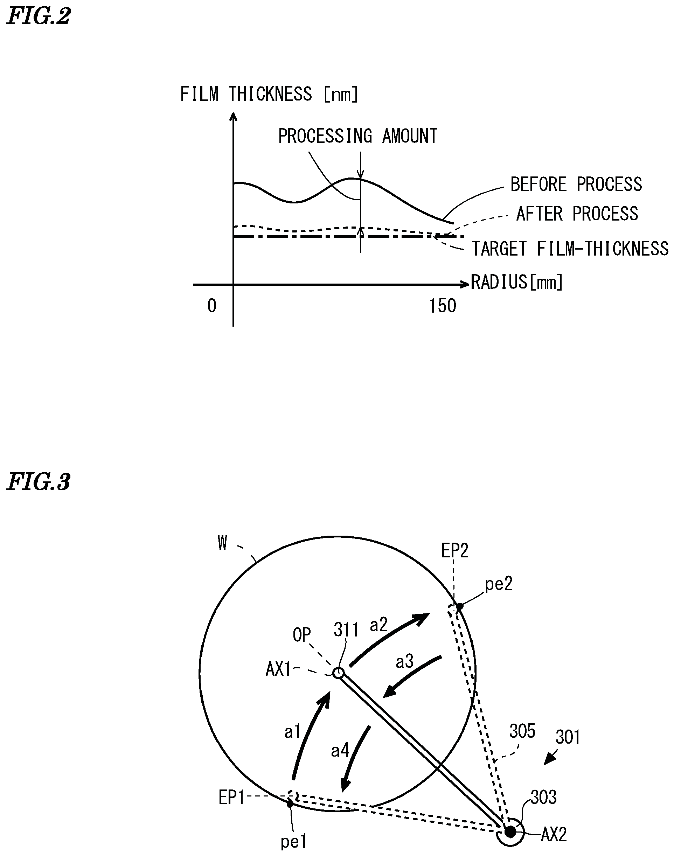

Here, the film process to be executed on the film of the substrate W in the present embodiment will be described. Fig. 2 is a diagram for explaining the film process. In Fig. 2, the ordinate indicates a film thickness, and the abscissa indicates a position in a radial direction of the substrate. The origin of the abscissa indicates the center of the substrate. It is desirable that the thickness of a film formed by the substrate processing apparatus 300 is uniform over the entire surface of the substrate W. Therefore, a target film-thickness is defined for the process to be executed by the substrate processing apparatus 300. The target film-thickness is indicated by the one-dot and dash line. The thickness of the film formed on the substrate W before being processed by the substrate processing apparatus 300 is indicated by the solid line. The substrate processing apparatus 300 executes the film process of supplying the etching liquid to the film on the substrate in accordance with a processing condition, described below, thereby adjusting the thickness of the film formed on the substrate W. The thickness of the film formed on the substrate W after the film process is executed by the substrate processing apparatus 300 is indicated by the dotted line.

The difference between the thickness of the film formed on the substrate W before the substrate W is processed by the substrate processing apparatus 300 and the thickness of the film formed on the substrate W after the substrate W is processed by the substrate processing apparatus 300 is a processing amount (etching amount). In other words, the processing amount indicates a film thickness by which the film thickness is reduced at each of a plurality of positions arranged in the radial direction of the substrate W by the process executed on the substrate W by the substrate processing apparatus 300. The processing amount is an example of a first processing amount.

The control device 50 in the present embodiment causes the substrate processing unit WU to execute the film process in accordance with the processing condition. The processing condition is stored in advance in the control device 50. In the present embodiment, a plurality of processing conditions are stored in the control device 50, by way of example. The processing condition includes a moving condition for moving the nozzle 311, a flow-rate condition for defining a flow rate at which the processing liquid is supplied from the nozzle 311 to the substrate W, and a rotation condition for defining a rotation speed of the substrate W. The moving condition includes moving speeds of the nozzle 311 for a plurality of different positions arranged in the radial direction of the substrate, and a reciprocation count indicating the number of times the nozzle 311 reciprocates in a moving range. The moving range will be described below. The flow-rate condition indicates a flow rate of the processing liquid discharged from the nozzle 311 at a point in time at which the nozzle 311 is located above each of the plurality of different positions arranged in the radial direction of the substrate. The rotation condition indicates a rotation speed of the substrate W at a point in time at which the nozzle 311 is located above each of the plurality of different positions arranged in the radial direction of the substrate.

In the present embodiment, a plurality of divided areas obtained by dividing the obverse surface of the substrate by a plurality of concentric circles having different radii are defined, and the moving condition, the flow-rate condition, and the rotation condition define a moving speed, a flow rate, and a rotation speed for each of the plurality of divided areas.

Here, the plurality of divided areas will be described. Fig. 3 is a diagram for explaining a change of a relative position of the nozzle 311 with respect to the substrate W. With reference to Fig. 3, the change of the relative position of the nozzle 311 with respect to the substrate W held by the spin chuck SC is shown. The nozzle 311 moves in an area above the substrate W held by the spin chuck SC. Because the nozzle 311 rotates about the second rotation axis AX2, the trajectory along which the nozzle 311 moves forms an arc. In plan view, the trajectory along which the nozzle 311 moves passes through a substrate center OP, which is the center of the substrate. Here, in regard to the trajectory along which the nozzle 311 moves, one end is indicated by a work end portion EP1 located farther inward than an end portion pe1 at the outer edge of the substrate W, and the other end is indicated by a work end portion EP2 located farther inward than an end portion pe2 at the outer edge of the substrate W. The trajectory along which the nozzle 311 moves represents the moving range of the nozzle 311. The scanning in which the nozzle 311 moves from the work end portion EP1 to the substrate center OP in plan view is indicated by an arrow a1, and the scanning in which the nozzle 311 moves from the substrate center OP to the work end portion EP2 in plan view is indicated by an arrow a2. Further, the scanning in which the nozzle 311 moves from the work end portion EP2 to the substrate center OP in plan view is indicated by an arrow a3, and the scanning in which the nozzle 311 moves from the substrate center OP to the work end portion EP1 in plan view is indicated by an arrow a4.

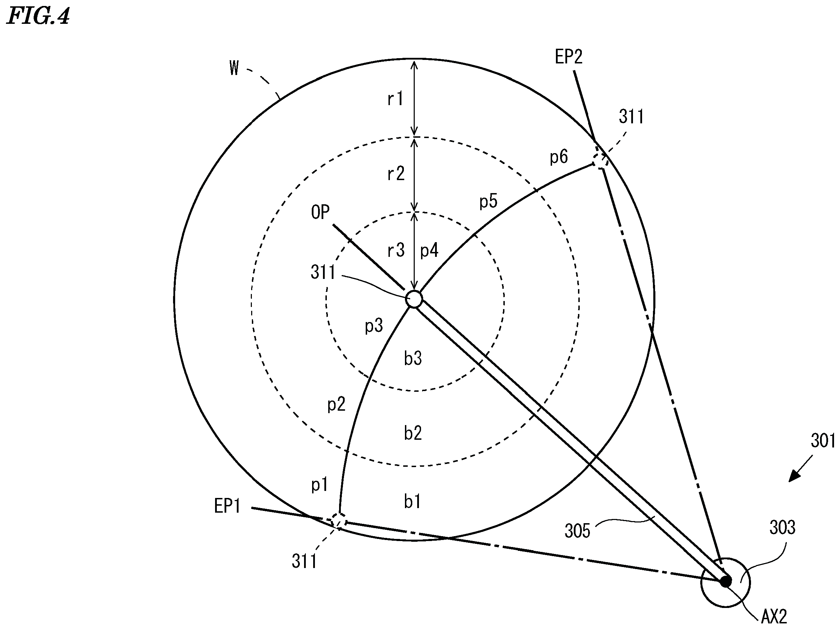

Fig. 4 is a diagram for explaining the divided areas. With reference to Fig. 4, three divided areas b1 to b3 obtained by dividing the upper surface of the substrate W by a plurality of concentric circles centered at the substrate center OP are shown. The divided area b3 is a circle, and the divided areas b1, b2 are rings. The divided area b1 is an example of a peripheral area. In the present embodiment, the radius of the divided area b1 and respective lengths r3, r2 of the respective divided areas b3, b2 in the radial direction of the substrate W are equal to one another. The radius of the divided area b1 and the respective lengths r3, r2 of the respective divided areas b3, b2 in the radial direction of the substrate W may be different from one another. The respective lengths r1, r2 of the respective divided areas b1, b2 in the radial direction of the substrate W and the radius r3 of the divided area b3 are preferably equal to or larger than an inner diameter of the nozzle 311.

The moving range of the nozzle 311 is defined based on the flow rate of the processing liquid discharged from the nozzle 311. When impinging on the substrate W, the processing liquid discharged from the nozzle 311 spreads to the surrounding area from the position of impingement on the obverse surface of the substrate W. The lower the flow rate of the processing liquid, the smaller an amount of spreading of the processing liquid. The position at which the processing liquid impinges on the substrate W is defined such that the area to which the processing liquid that has been discharged from the nozzle 311 and impinges on the substrate W spreads is within the obverse surface of the substrate W. Therefore, the lower the flow rate of the processing liquid discharged from the nozzle 311, the closer the work end portions EP1, EP2 can be brought toward the end portions pe1, pe2 at the outer edge of the substrate W in plan view.

Sections p1 to p6 above which the nozzle 311 moves are defined based on the trajectory along which the nozzle 311 moves in the radial direction of the substrate in a scanning period during which the nozzle 311 moves in the moving range from the work end portion EP1 to the work end portion EP2. The sections p1 to p6 are obtained by dividing the moving range by the divided areas b1 to b3. The sections p1 to p3 represent the divided areas b1 to b3, which the nozzle 311 crosses in plan view while moving along the trajectory between the work end portion EP1 and the substrate center OP. For example, the section p1 represents the divided area b1, which the nozzle 311 crosses in plan view while moving between the work end portion EP1 and the substrate center OP in plan view. Further, the sections p4 to p6 represent the divided areas b1 to b3, which the nozzle 311 crosses in plan view while moving along the trajectory between the work end portion EP2 and the substrate center OP. For example, the section p6 represents the divided area b1, which the nozzle 311 crosses in plan view while moving between the work end portion EP2 and the substrate center OP in plan view. The number of the divided areas b1 to b3 is not limited to three, and can be set to any value. In this case, the number of divisions of the moving range, in other words, the number of the plurality of sections varies.

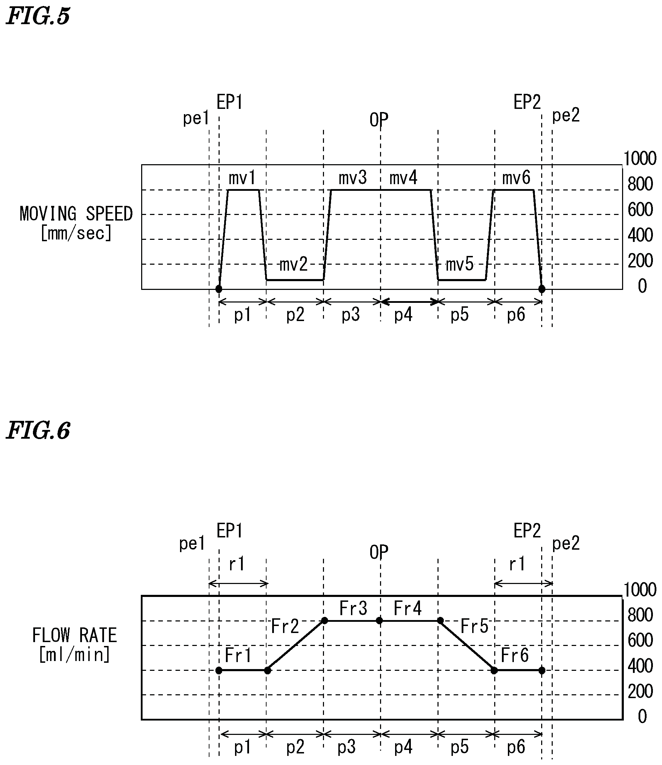

Fig. 5 is a diagram showing one example of a moving speed of the nozzle in the moving condition. With reference to Fig. 5, the moving speed of the nozzle 311 in a case in which the nozzle 311 is located above the work end portion EP1 is set to zero. In the present embodiment, in regard to the moving condition, the period during which the moving speed is zero is predetermined. Therefore, the nozzle 311 stops for a predetermined period of time in a case in which being located above the work end portion EP1.

In a period during which the nozzle 311 is located above the section p1, the moving speed of the nozzle 311 is set to a speed mv1. Because the nozzle 311 moves at the speed of zero when being located above the work end portion EP1, the moving speed of the nozzle 311 increases from zero to the speed mv1 when the nozzle 311 is located above the portion in the vicinity of the work end portion EP1 of the section p1. Further, in a period during which the nozzle 311 is located above the section p2, the moving speed of the nozzle 311 is set to a speed mv2. Above the vicinity of a portion of the section p1 being in contact with the section p2, the moving speed decreases from the speed mv1 to the speed mv2.

In a period during which the nozzle 311 is located above the section p3, the moving speed of the nozzle 311 is set to a speed mv3. The speed mv3 is higher than the speed mv2 and is equal to the speed mv1. Above the vicinity of a portion of the section p3 being in contact with the section p2, the moving speed increases from the speed mv2 to the speed mv3.

In a period during which the nozzle 311 is located above the section p4, the moving speed of the nozzle 311 is set to a speed mv4. The speed mv4 is equal to the speed mv3. In a period during which the nozzle 311 is located above the section p5, the moving speed is set to a speed mv5. The speed mv5 is lower than the speed mv4 and is equal to the speed mv2. Above the vicinity of a portion of the section p4 being in contact with the section p5, the moving speed decreases from the speed mv4 to the speed mv5.

In a period during which the nozzle 311 is located above the section p6, the moving speed of the nozzle 311 is set to a speed mv6. The speed mv6 is higher than the speed mv5 and is equal to the speed mv1. Above the vicinity of a portion of the section p6 being in contact with the section p5, the moving speed decreases from the speed mv5 to the speed mv6.

The moving speed of the nozzle 311 in a case in which the nozzle 311 is located above the work end portion EP2 is set to zero. In the present embodiment, in the moving condition, the period during which the moving speed is zero is predetermined. Therefore, the nozzle 311 stops for a predetermined period of time in a case in which being located above the work end portion EP2. Because the moving speed of the nozzle 311 is zero when the nozzle 311 is located above the work end portion EP2, the moving speed of the nozzle 311 decreases from the speed mv6 to zero when the nozzle 311 is located above the vicinity of the work end portion EP1 of the section p6.

In a case in which the nozzle 311 moves from the work end portion EP1 to the work end portion EP2 in plan view, the nozzle 311 stops above the work end portion EP1 for the predetermined period of time and then accelerates to the speed mv1. Then, the nozzle 311 decelerates to the speed mv2 as approaching the section p2 in plan view, and moves above the section p2 at the speed mv2. When entering the section p3 in plan view, the nozzle 311 accelerates from the speed mv2 to the speed mv3. Further, the nozzle 311 moves above the section p4 at the speed mv4 that is equal to the speed mv3, decelerates to the speed mv5 as approaching the section p5 in plan view, and moves above the section p5 at the speed mv5. When entering the section p6 in plan view, the nozzle 311 accelerates from the speed mv5 to the speed mv6. Further, the nozzle 311 moves above the section p6 at the speed mv6, and decelerates to the speed of zero as approaching the work end portion EP2 in plan view. Then, the nozzle 311 stops above the work end portion EP2 for the predetermined period of time.

In a case in which moving from the work end portion EP2 to the work end portion EP1 in plan view, the nozzle 311 stops above the work end portion EP2 for the predetermined period of time and then accelerates to the speed mv6. Then, the nozzle 311 decelerates to the speed mv5 as approaching the section p5 in plan view, and moves above the section p5 at the speed mv5. When entering the section p4 in plan view, the nozzle 311 accelerates from the speed mv5 to the speed mv4. Further, the nozzle 311 moves above the section p3 at the speed mv3 that is equal to the speed mv4, decelerates to the speed mv2 as approaching the section p2 in plan view, and moves above the section p2 at the speed mv2. When entering the section p1 in plan view, the nozzle 311 accelerates from the speed mv2 to the speed mv1. Further, the nozzle 311 moves above the section p1 at the speed mv1, and decelerates to the speed of zero as approaching the work end portion EP1 in plan view. Then, the nozzle 311 stops above the work end portion EP1 for the predetermined period of time.

Fig. 6 is a diagram showing one example of the flow-rate condition. The flow-rate condition defines a value of the flow rate of the processing liquid in a case in which the nozzle 311 is located above each of the plurality of sections p1 to p6 of the substrate W. With reference to Fig. 6, the flow rate of the processing liquid for each section will be described. In regard to the sections p1 to p3, the flow rate of the processing liquid is constant and set to the lowest flow rate Fr1 in a period during which the nozzle 311 is located above the section p1, and the flow rate of the processing liquid is constant and set to the highest flow rate Fr3 in a period during which the nozzle 311 is located above the section p3. In this case, the flow rate Fr2 of the processing liquid in a period during which the nozzle 311 is located above the section p2 is set such that the value of the flow rate Fr2 increases as the nozzle 311 moves from the section p1 to the section p3 in plan view.

In regard to the sections p4 to p6, the flow rate of the processing liquid is constant and set to the highest flow rate Fr4 in a period during which the nozzle 311 is located above the section p4, and the flow rate of the processing liquid is constant and set to the lowest flow rate Fr6 in a period during which the nozzle 311 is located above the section p6. In this case, a flow rate Fr5 of the processing liquid in a period during which the nozzle 311 is located above the section p5 is set such that the value of the flow rate Fr5 decreases as the nozzle 311 moves from the section p4 toward the section p6 in plan view.

In the flow-rate condition, the value of the flow rate of the processing liquid in a case in which the nozzle 311 is located above each of the sections p1, p6 is set lower than the value of the flow rate of the processing liquid in a case in which the nozzle 311 is located above each of the other sections p2 to p5.

Because the flow rate of the processing liquid in a case in which the nozzle 311 is located above each of the sections p1, p6 is relatively low, the extent of spreading of the processing liquid on the obverse surface of the substrate W in a case in which the nozzle 311 is located above each of the sections p1, p6 is relatively small. As described above, the moving range of the nozzle 311 is defined by the flow rate of the processing liquid in a case in which the nozzle 311 is located above each of the sections p1, p6. Because the flow rate of the processing liquid in a case in which the nozzle 311 is located above each of the sections p1, p6 is relatively low, the work end portions EP1, EP2 and the work end portions EP1, EP2 can be brought close to the end portions pe1, pe2 at the outer edge of the substrate W in plan view. This improves the efficiency of the film process in the peripheral area in the vicinity of the outer peripheral end of the substrate W. Further, because an amount of the processing liquid, which impinges on the chuck pin 306 after impinging on the substrate W and spreading on the obverse surface of the substrate W, is relatively small, an amount of the processing liquid which impinges on the chuck pin 306 and splashes outwardly of the substrate W can be reduced.

### (2) Substrate Process Controlled by Controller 50

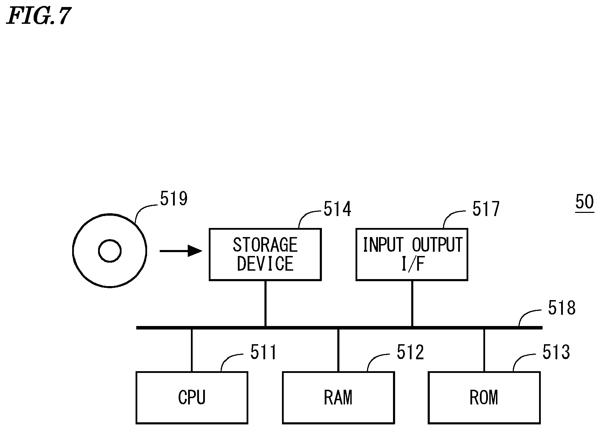

Fig. 7 is a diagram showing one example of the configuration of the control device 50. With reference to Fig. 7, the control device 50 includes a CPU 511, a RAM 512, a ROM 513, a storage device 514, and an input-output I/F 517. The CPU 511, the RAM 512, the ROM 513, the storage device 514, and the input-output I/F 517 are connected to a bus 518.

The RAM 512 is used as a work area for the CPU 511. A system program is stored in the ROM 513. The storage device 514 includes a storage medium such as a hard disc or a semiconductor memory, and stores a program.

Further, a CD-ROM 519 recording a program is attachable to and detachable from the storage device 514. The CPU 511 loads the program recorded in the hard disc, the semi-conductor memory, or the CD-ROM 519 into the RAM 512, and executes the program. The input-output I/F 517 is a communication interface, and can connect the CPU 511 to an external device.

A recording medium storing a program to be executed by the CPU 511 is not limited to the CD-ROM 519. It may be an optical disc (magnetic optical disc (MO)/mini disc (MD))/digital versatile disc (DVD)), an IC card, an optical card, and a semiconductor memory such as a mask ROM or an erasable programmable ROM (EPROM). Further, the CPU 511 may download a program from a computer connected to the network and store the program in the storage device 514. Alternatively, the computer connected to the network may write the program in the storage device 514, and the program stored in the storage device 514 may be loaded into the RAM 512 and executed in the CPU 511. The program referred to here includes not only a program directly executable by the CPU 111 but also a source program, a compressed program, an encrypted program, and the like.

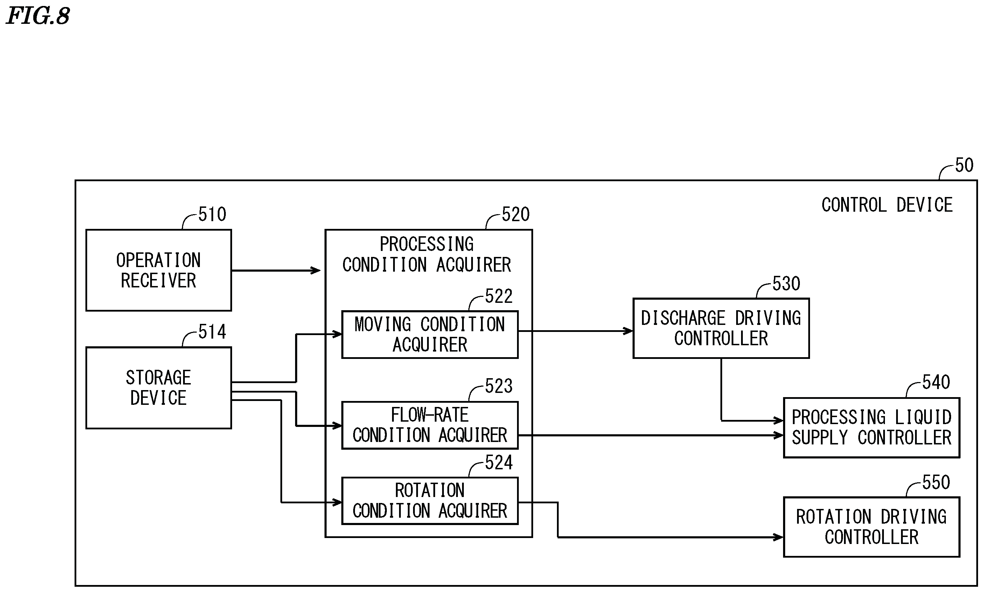

Fig. 8 is a block diagram showing one example of the functional configuration of the control device 50. The control device 50 includes an operation receiver 510, a storage device 514, a processing condition acquirer 520, a discharge driving controller 530, a processing liquid supply controller 540, and a rotation driving controller 550. The operation receiver 510 receives an input operation performed by a user on an input device such as a keyboard. The operation receiver 510 receives processing recipe information input by the user. The processing recipe information includes processing condition identification information for identifying a processing condition for execution of the film process by the substrate processing unit WU on the substrate W to be processed. The processing condition acquirer 520 acquires the processing condition by reading the processing condition identified by the processing condition identification information included in the processing recipe information from the storage device 514.

The processing condition acquirer 520 includes a moving condition acquirer 522, a flow-rate condition acquirer 523, and a rotation condition acquirer 524. The moving condition acquirer 522 acquires a moving condition included in the processing condition read from the storage device 514, and outputs the acquired moving condition to the discharge driving controller 530. Here, the moving condition including the moving speed shown in Fig. 5 and a reciprocation count of one are acquired, by way of example. The flow-rate condition acquirer 523 acquires a flow-rate condition included in the processing condition read from the storage device 514, and outputs the acquired flow-rate condition to the processing liquid supply controller 540. Here, the flow-rate condition shown in Fig. 6 is acquired, by way of example.

The rotation condition acquirer 524 acquires a rotation condition included in the processing condition read from the storage device 514, and outputs the acquired rotation condition to the rotation driving controller 550. The rotation condition indicates a rotation speed of the substrate for each of a plurality of positions on the substrate. The rotation speed indicates the number of rotations of the substrate per unit time. Here, the rotation condition in which the rotation speeds of the substrate for the plurality of respective positions on the substrate are the same rotation speed R is acquired, by way of example.

The discharge driving controller 530 controls the nozzle motor 303 and moves the nozzle 311 above the substrate W in accordance with the moving condition received from the moving condition acquirer 522. In a period during which moving the nozzle 311 above the substrate W, the discharge driving controller 530 detects a relative position of the nozzle 311 with respect to the substrate W, and outputs the detected relative position to the processing liquid supply controller 540.

The processing liquid supply controller 540 receives the flow-rate condition from the flow-rate condition acquirer 523, and receives the relative position of the nozzle 311 with respect to the substrate W from the discharge driving controller 530. The processing liquid supply controller 540 controls the processing liquid supplier PS in accordance with the flow-rate condition and the relative position of the nozzle 311 with respect to the substrate W. Specifically, the processing liquid supply controller 540 determines the flow rate of the processing liquid defined by the flow-rate condition for the relative position of the nozzle 311 with respect to the substrate W, and controls the processing liquid supplier PS such that the processing liquid is supplied to the nozzle 311 at the determined flow rate.

The rotation driving controller 550 controls the spin motor SM in accordance with the rotation condition. Here, the rotation condition specifies the constant rotation speed R. Therefore, the rotation driving controller 550 controls the spin motor SM such that the substrate W is rotated at the rotation speed R defined by the rotation condition.

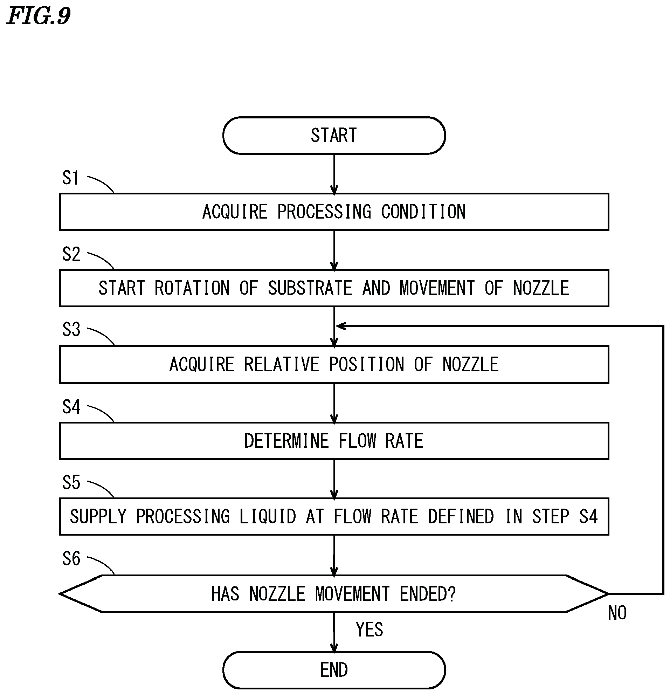

Fig. 9 is a flowchart showing a flow of the film process. The film process is executed by the CPU 511 included in the control device 50 when the CPU 511 executes a substrate processing program stored in the RAM 512. With reference to Fig. 9, the CPU 511 included in the control device 50 acquires the processing condition (step S1). Specifically, the CPU 511 receives the processing recipe information input by the user to the input device such as the keyboard, and reads, from the storage device 514, the processing condition specified by the received processing recipe information. The processing condition identified by the processing condition identification information included in the processing recipe information is read from among the plurality of processing conditions stored in the storage device 514.

In the step S2, the CPU 511 starts the rotation of the substrate W and the movement of the nozzle 311. Specifically, the CPU 511 controls the spin motor SM in accordance with the rotation condition included in the processing condition to rotate the substrate W. Further, the CPU 511 controls the nozzle motor 303 in accordance with a moving speed and a reciprocation count defined by the moving condition included in the processing condition to move the nozzle 311. Because the constant rotation speed is defined by the rotation condition, the substrate W rotates at the constant rotation speed. Further, the nozzle 311 starts moving at the moving speed defined by the moving condition.

In the next step S3, the CPU 511 acquires a position of the nozzle 311. The relative position of the nozzle 311 with respect to the substrate W is acquired. The CPU 511 acquires the relative position based on an instruction such as the number of pulses output to the nozzle motor 303. Further, the CPU 511 may acquire the relative position based on a rotation angle of the nozzle motor 303 detected by an encoder.

In the next step S4, the CPU 511 determines a flow rate. Specifically, the CPU 511 determines the flow rate of the processing liquid based on the flow-rate condition and the relative position of the nozzle 311 with respect to the substrate W. Using the flow-rate condition included in the processing condition acquired in the step S1, the CPU 511 determines the flow rate defined by the flow-rate condition in correspondence with the relative position of the nozzle 311 acquired in the step S3.

In the next step S5, the CPU 511 supplies the processing liquid at the flow rate defined in the step S4. The CPU 511 controls the processing liquid supplier PS to supply the processing liquid to the nozzle 311 at the flow rate determined in the step S4. In the next step S6, the CPU 511 determines whether the movement of the nozzle 311 has ended. Here, whether the movement of the nozzle 311 has ended is determined by whether the number of times the nozzle 311 reciprocates in the moving range has reached the reciprocation count included in the moving condition. If the movement of the nozzle 311 has not ended, the process returns to the step S3. If the movement of the nozzle 311 has ended, the process ends.

### (3) Effects of Embodiment

With the substrate processing apparatus 300 of the above-mentioned embodiment, the moving speed of the nozzle 311 and the flow rate of the processing liquid supplied to the nozzle 311 are adjusted for each of the plurality of different positions arranged on the substrate W in the radial direction of the substrate W. A peripheral speed of the substrate W varies with a position of the nozzle 311 in the radial direction of the substrate W. Further, the processing liquid supplied onto the substrate W moves outwardly due to a centrifugal force. Because the moving speed of the nozzle 311 and the flow rate of the processing liquid supplied to the nozzle 311 are adjusted for each of the plurality of positions, a film formed on the substrate W can be efficiently processed.

With the substrate processing apparatus 300 of the above-mentioned embodiment, the flow rate of the processing liquid supplied to the nozzle 311 in a period during which the nozzle 311 is located above the divided area b1 (see Fig. 4) located in the periphery of the substrate W is lower than the flow rate of the processing liquid supplied to the nozzle 311 in a period during which the nozzle 311 is located above each of the other divided areas b2, b3. This can reduce the area of the substrate W to which the processing liquid spreads after the processing liquid is supplied to the divided area b1 on the substrate W. This suppresses outward splashing, caused by the rotation of the substrate W, of the processing liquid that has been supplied to the divided area b1. Thus, it is possible to provide the substrate processing apparatus 300 capable of reducing the consumption of the processing liquid for processing the film formed on the substrate W.

Further, in a period during which the nozzle 311 is located above the divided area b1 (see Fig. 4) located in the periphery of the substrate, the flow rate of the processing liquid discharged from the nozzle 311 is reduced. This can suppress splashing, to the outside of the substrate W, of the processing liquid that has been supplied to the substrate W. Furthermore, it is possible to suppress splashing of the processing liquid to the outside of the substrate W by reducing an amount of the processing liquid impinging on the chuck pin 306.

When the direction in which the nozzle 311 moves is reversed above the divided area b1 located in the periphery of the substrate W, the moving speed of the nozzle 311 is zero. In the divided area b1, even in a case in which the flow rate of the processing liquid supplied from the nozzle 311 is low, the period of time during which the processing liquid is supplied is increased. This can set a processing amount of the film in the divided area b1 to an appropriate value.

### (4) First Modified Example

The rotation condition indicates a rotation speed of the substrate W at a point in time at which the nozzle 311 is located above each of the plurality of different positions arranged in the radial direction of the substrate. In the above-mentioned embodiment, the rotation speed is constant according to the rotation condition. In a substrate processing apparatus 300 in a first modified example, according to a rotation condition, the rotation speed of the nozzle 311 varies depending on a position above which the nozzle 311 is located among the plurality of different positions arranged in the radial direction of the substrate.

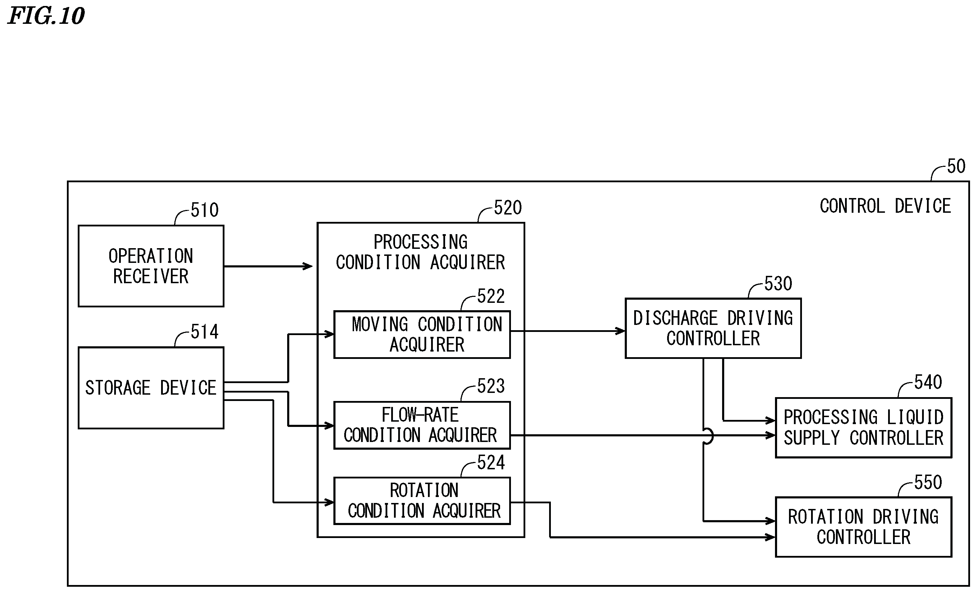

Fig. 10 is a block diagram showing one example of the functions of a control device 50 according to the first modified example. With reference to Fig. 10, the differences from the functions shown in Fig. 8 are that a rotation condition output from the rotation condition acquirer 524 to the rotation driving controller 550 is different, and that a relative position of the nozzle 311 with respect to the substrate W is input from the discharge driving controller 530 to the rotation driving controller 550. The other functions are the same as those shown in Fig. 8. A description thereof will therefore not be repeated.

The rotation driving controller 550 receives the rotation condition from the rotation condition acquirer 524, and receives the relative position of the nozzle 311 with respect to the substrate W from the discharge driving controller 530. The rotation driving controller 550 controls the spin motor SM in accordance with the rotation condition and the relative position of the nozzle 311 with respect to the substrate W. Specifically, the rotation driving controller 550 determines the rotation speed defined by the rotation condition for the relative position of the nozzle 311 with respect to the substrate W, and controls the spin motor SM such that the substrate W rotates at the determined rotation speed.

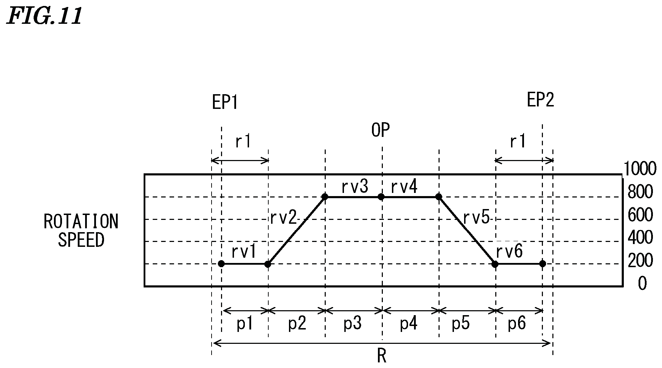

Fig. 11 is a diagram showing one example of the rotation condition in the first modified example. The rotation condition indicates the rotation speed of the substrate W in a case in which the nozzle 311 is located above each of the plurality of sections p1 to p6 of the substrate W. With reference to Fig. 11, the rotation speed of the substrate W for each section will be described. In regard to the sections p1 to p3, the rotation speed of the substrate W is constant and set to a rotation speed rv1, which is the lowest rotation speed, in a period during which the nozzle 311 is located above the section p1, and the rotation speed of the substrate W is constant and set to a rotation speed rv3, which is the highest rotation speed, in a period during which the nozzle 311 is located above the section p3. In this case, a rotation speed rv2 of the substrate W in a period during which the nozzle 311 is located above the section p2 is set such that the value of the rotation speed increases as the nozzle 311 moves from the section p1 toward the section p3 in plan view.

In regard to the sections p4 to p6, the rotation speed of the substrate W is constant and set to a rotation speed rv4, which is the highest rotation speed, in a period during which the nozzle 311 is located above the section p4, and the rotation speed of the substrate W is constant and set to a rotation speed rv6, which is the lowest rotation speed, in a period during which the nozzle 311 is located above the section p6. In this case, a rotation speed rv5 of the substrate W in a period during which the nozzle 311 is located above the section p5 is set such that the value of the rotation speed decreases as the nozzle 311 moves from the section p4 toward the section p6 in plan view.

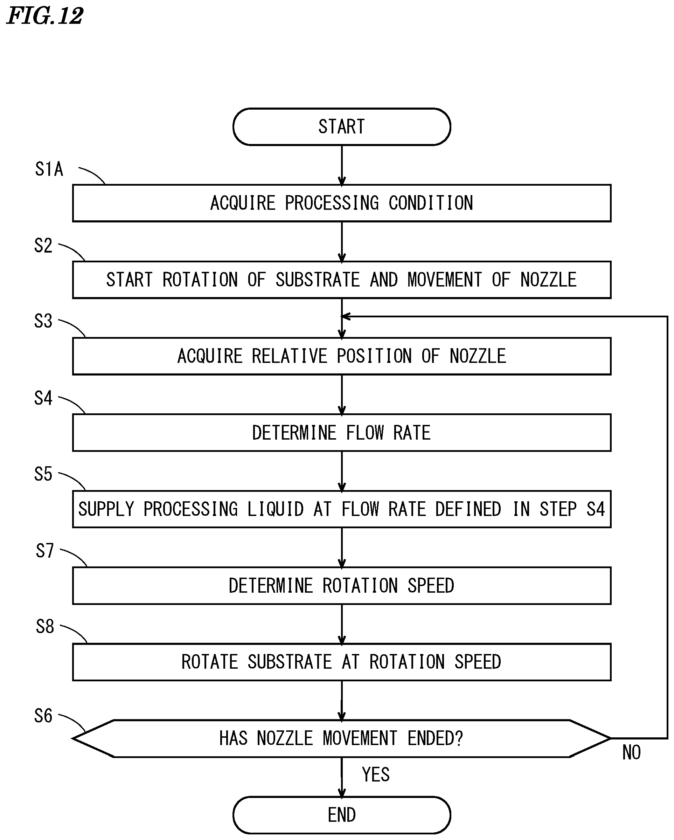

Fig. 12 is a flowchart showing one example of a flow of a film process in the first modified example. The differences of the process shown in Fig. 12 from the process shown in Fig. 9 are that the step S1 is changed to the step S1A, and the steps S7 and S8 are inserted between the steps S5 and S6. The other processes are the same as those shown in Fig. 9. A description thereof will therefore not be repeated here.

The CPU 511 acquires a processing condition (step S1A). Specifically, the CPU 511 receives processing recipe information input by the user to the input device such as the keyboard, and reads, from the storage device 514, the processing condition specified by the received processing recipe information. The processing condition identified by processing condition identification information included in the processing recipe information is read from among a plurality of processing conditions stored in the storage device 514. The processing condition acquired here includes a moving condition, a flow-rate condition, and a rotation condition. The rotation condition is the rotation condition shown in Fig. 11.

The CPU 511 determines a rotation speed in the step 7. Specifically, the CPU 511 determines the rotation speed based on the rotation condition, and a relative position of the nozzle 311 with respect to the substrate W. By using the rotation condition included in the processing condition acquired in the step S1A, the CPU 511 determines, in correspondence with the relative position of the nozzle 311 acquired in the step S3, the rotation speed defined by the rotation condition.

In the next step S8, the CPU 511 rotates the substrate W at the determined rotation speed, and the process proceeds to the step S6. The CPU 511 controls the spin motor SM to rotate the substrate W at the rotation speed determined in the step S7.

In the first modified example, the rotation speed at which the substrate W is rotated is adjusted in addition to the moving speed of the nozzle 311 and the flow rate of the processing liquid supplied by the nozzle 311 for each of the plurality of sections p1 to p6. This facilitates adjustment of an amount of the processing liquid supplied to each of different positions arranged in the radial direction of the substrate W. Further, the film formed on the substrate W can be processed more efficiently. In particular, when the nozzle 311 is located above each of the sections p1, p6 which is in the outermost divided area b1 of the substrate W, the rotation speed is the lowest. After landing on the substrate W, the processing liquid discharged from the nozzle 311 receives a centrifugal force from the rotating substrate W to move outwardly of the substrate W on the obverse surface of the substrate W. Because the rotation speed is the lowest, the centrifugal force applied to the processing liquid from the substrate W is relatively small. This can reduce, as much as possible, the rotation speed when the processing liquid moving on the upper surface of the substrate W impinges on the chuck pin 330. Therefore, it is possible to suppress an amount of splashing of the processing liquid that impinges on the chuck pin 330.

Also, the farther outward a position in the substrate W, the higher the circumferential speed of the substrate W. Therefore, the processing liquid is not likely to be affected by the heat of vaporization. In the first modified example, because the rotation speed is the lowest when the nozzle 311 is located above each of the sections p1, p6 which are in the divided area b1 located outermost of the substrate W, the effect of heat of vaporization on the processing liquid can be relatively small.

### (5) Second Modified Example

With the substrate processing apparatus 300 of the above-mentioned first embodiment, the moving speed of the nozzle 311 and the flow rate of the processing liquid supplied to the nozzle 311 are adjusted for each of the plurality of different positions arranged on the substrate W in the radial direction of the substrate W. In a second modified example, the substrate processing apparatus 300 in the first embodiment further regulates a temperature of the processing liquid for each of the plurality of positions arranged on the substrate W in the radial direction of the substrate W. The differences of the substrate processing apparatus 300 in the second modified example from the substrate processing apparatus 300 in the first embodiment will be mainly described below.

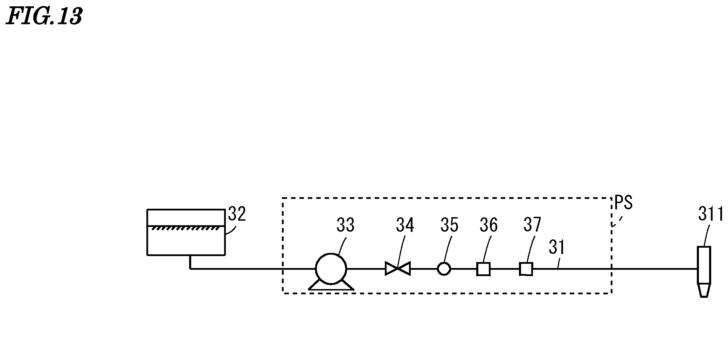

Fig. 13 is a diagram showing one example of the configuration of a processing liquid supplier PS in the second modified example. With reference to Fig. 13, the difference of the processing liquid supplier PS in the second modified example from the processing liquid supplier PS shown in Fig. 1 is that a heater 37 is added. The heater 37 is disposed farther downstream than the flow-rate sensor 36 of the supply pipe 31. The heater 37 is an electric heater. The heater 37 is controlled by the control device 50, and heats the processing liquid flowing through the supply pipe 31.

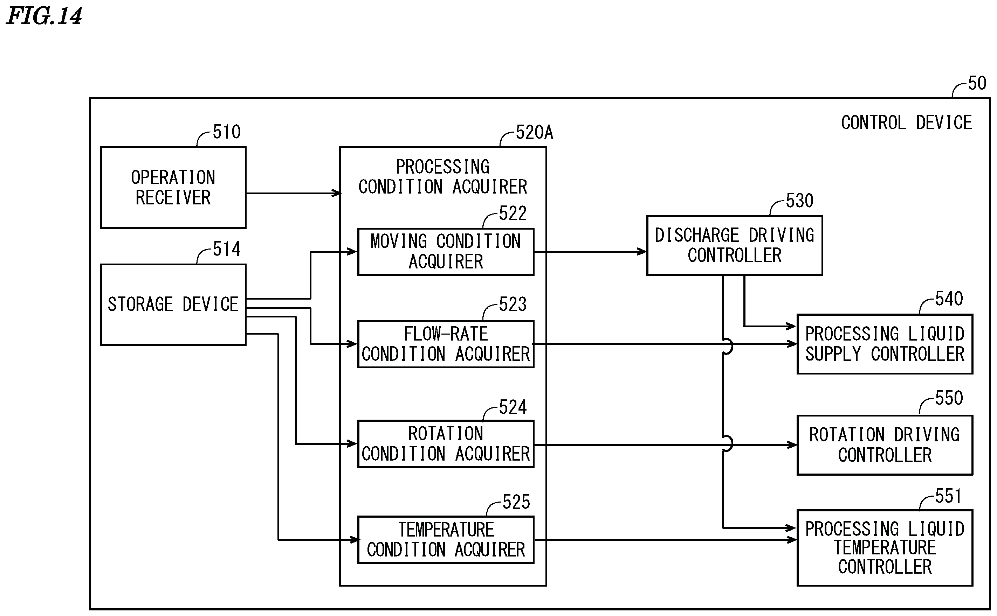

Fig. 14 is a block diagram showing one example of the functions of a control device 50 according to the second modified example. With reference to Fig. 14, the differences from the functions shown in Fig. 8 are that the processing condition acquirer 520 is changed to a processing condition acquirer 520A, and that a processing liquid temperature controller 551 is added. The other functions shown in Fig. 14 are the same as those shown in Fig. 8. A description thereof will therefore not be repeated.

The processing condition acquirer 520A includes a temperature condition acquirer 525. The temperature condition acquirer 525 acquires a temperature condition included in a processing condition read from the storage device 514, and outputs the acquired temperature condition to the processing liquid temperature controller 551. The temperature condition is the information relating to the temperature of the processing liquid for each of the plurality of positions on the substrate W. Here, the temperature condition is the information that defines the state of the heater 37 for each of the plurality of positions on the substrate W. The state of the heater 37 is either an ON state or an OFF state.

The processing liquid temperature controller 551 receives the temperature condition from the temperature condition acquirer 525, and receives a relative position of the nozzle 311 with respect to the substrate W from the discharge driving controller 530. The processing liquid temperature controller 551 controls the heater 37 in accordance with the temperature condition, and the relative position of the nozzle 311 with respect to the substrate W. Specifically, the processing liquid temperature controller 551 determines the state of the heater 37 defined by the temperature condition for the relative position of the nozzle 311 with respect to the substrate W, and controls the heater 37 to bring the heater 37 into the determined state.

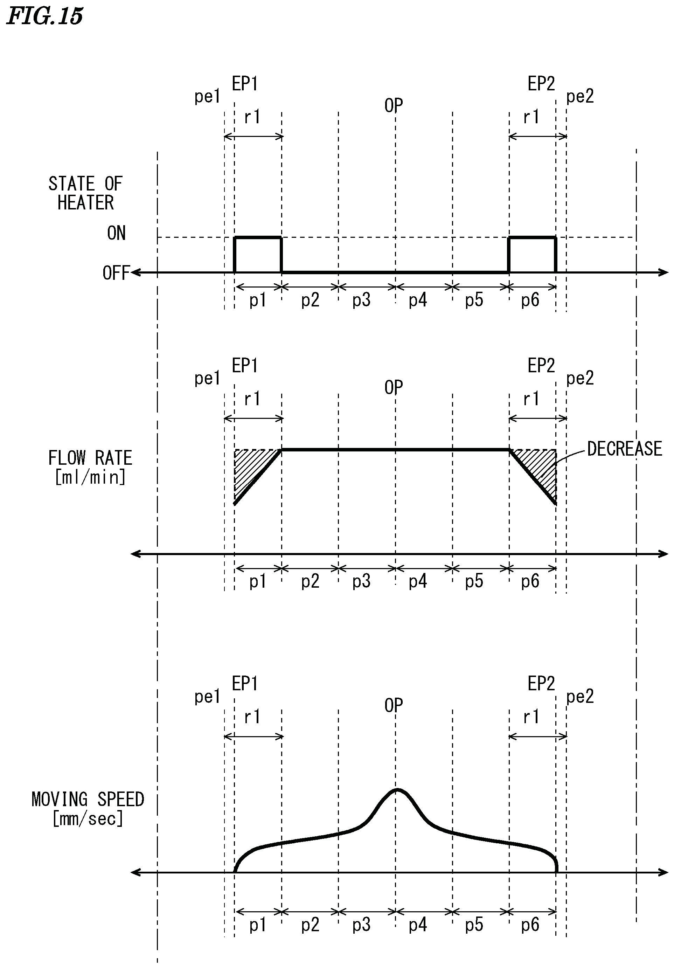

Fig. 15 is a diagram showing one example of the processing condition in the second modified example. With reference to Fig. 15, the processing condition for the six sections p1 to p6 is shown. As the processing condition, the state of the heater 37 is shown in the upper field, the flow rate of the processing liquid is shown in the middle field, and the moving speed of the nozzle 311 is shown in the lower field.

With reference to the moving speed of the nozzle 311 shown in the lower field, the moving speed of the nozzle 311 in a case in which the nozzle 311 is located above the work end portion EP1 is set to zero. In a period during which the nozzle 311 is located above each of the sections p1 to p3, the moving speed of the nozzle 311 increases. In a period during which the nozzle 311 is located above each of the sections p4, p6, the moving speed of the nozzle 311 decreases. In a period during which the nozzle 311 is located above each of the sections p1 to p6, the moving speed of the nozzle 311 changes while its acceleration changes.

With reference to the flow rate of the processing liquid shown in the middle field, in a period during which the nozzle 311 moves above the section p1, the value of the flow rate of the processing liquid is set to increase. In this case, the flow rate of the processing liquid in the period during which the nozzle 311 is located above the section p1 is set to increase as the nozzle 311 moves from the section p1 toward the section p2 in plan view. In a period during which the nozzle 311 moves above each of the sections p2 to p5, the flow rate of the processing liquid is constant and set to the highest flow rate. In a period during which the nozzle 311 moves above the section p6, the value of the flow rate of the processing liquid is set to decrease. In this case, the value of the flow rate of the processing liquid in a period during which the nozzle 311 is located above the section p6 is set to decrease as the nozzle 311 moves toward the work end portion EP2 in plan view.

In the flow-rate condition, the value of the flow rate of the processing liquid in a case in which the nozzle 311 is located above each of the sections p1, p6 is set lower than the value of the flow rate of the processing liquid in a case in which the nozzle 311 is located above each of the other sections p2 to p5. Because the flow rate of the processing liquid in a case in which the nozzle 311 is located above each of the sections p1, p6 is relatively low, the consumption of the processing liquid in each of the sections p1, p6 can be reduced. This can also reduce an amount of the processing liquid splashing outwardly of the substrate W.

With reference to the state of the heater 37 shown in the upper field, in a period during which the nozzle 311 moves above each of the sections p1, p6, the state of the heater 37 is set to the ON state. In a period during which the nozzle 311 is located above each of the sections p2 to p5, the state of the heater 37 is set to the OFF state. The temperature of the processing liquid in the period during which the nozzle 311 is located above each of the sections p1, p6 is higher than the temperature of the processing liquid in a period during which the nozzle 311 is located above each of the sections p2 to p5.

The flow rate of the processing liquid in a period during which the nozzle 311 moves above each of the sections p1, p6 is lower than the flow rate of the processing liquid in a period during which the nozzle 311 moves above each of the sections p2 to p5. In contrast, the temperature of the processing liquid in the period during which the nozzle 311 moves above each of the sections p1, p6 is higher than the temperature of the processing liquid in the period during which the nozzle 311 moves above each of the sections p2 to p5. Therefore, a processing amount of the film in the sections p1 to p6 can be made close to uniform.

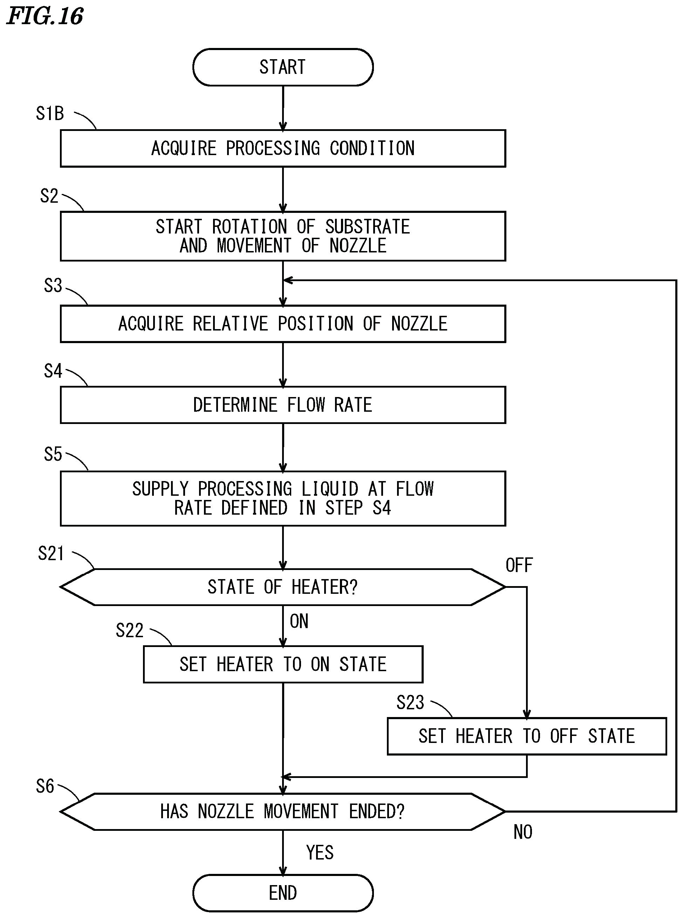

Fig. 16 is a flowchart showing one example of a flow of a film process in the second modified example. The differences of the process shown in Fig. 16 from the process shown in Fig. 9 are that the step S1 is changed to the step S1B, and the steps S21 to S23 are inserted between the steps S5 and S6. The other processes are the same as those shown in Fig. 9. A description thereof will therefore not be repeated here.

The CPU 511 acquires a processing condition (step S1B). Specifically, the CPU 511 receives processing recipe information input by the user to the device such as the keyboard, and reads, from the storage device 514, the processing condition specified by the received processing recipe information. The processing condition identified by processing condition identification information included in the processing recipe information is read from among a plurality of processing conditions stored in the storage device 514. The processing condition acquired here includes a moving condition, a flow-rate condition, and a temperature condition that are shown in Fig. 15.

In the step S21, the CPU 511 branches the process depending on a state of the heater 37. According to the temperature condition included in the processing condition acquired in the step S1B, the CPU 511 acquires the state of the heater 37 defined for the position of the nozzle 311 acquired in the step S3. If the state of the heater 37 is the ON state, the process proceeds to the step S22. If the state of the heater 37 is the OFF state, the process proceeds to the step S23. In the step S22, the CPU 511 sets the heater 37 to the ON state, and the process proceeds to the step S6. In the step S23, the CPU 511 sets the heater 37 to the OFF state, and the process proceeds to the step S6.

In the second modified example, for each of the plurality of sections p1 to p6, the temperature of the processing liquid is regulated in addition to the adjustment of the moving speed of the nozzle 311 and the adjustment of the flow rate of the processing liquid supplied by the nozzle 311. This facilitates adjustment of a processing amount of the film for each of the different positions arranged in the radial direction of the substrate W. Thus, the film formed on the substrate W can be processed more efficiently.

The substrate processing apparatus 300 in the second modified example may adjust the rotation speed of the substrate W for each of the plurality of sections p1 to p6, similarly to the substrate processing apparatus 30 in the first modified example.

### (6) Third Modified Example

The substrate processing apparatus 300 in the second modified example regulates the temperature of the processing liquid by setting the state of the heater 37 to the ON state or the OFF state. A substrate processing apparatus 300 in a third modified example regulates the temperature of the processing liquid by changing the heating power of the heater 37. The differences of the substrate processing apparatus 300 in the third modified example from the substrate processing apparatus 300 in the second modified example will be mainly described below. The configuration of a processing liquid supplier PS in the third modified example is the same as the configuration shown in Fig. 13.

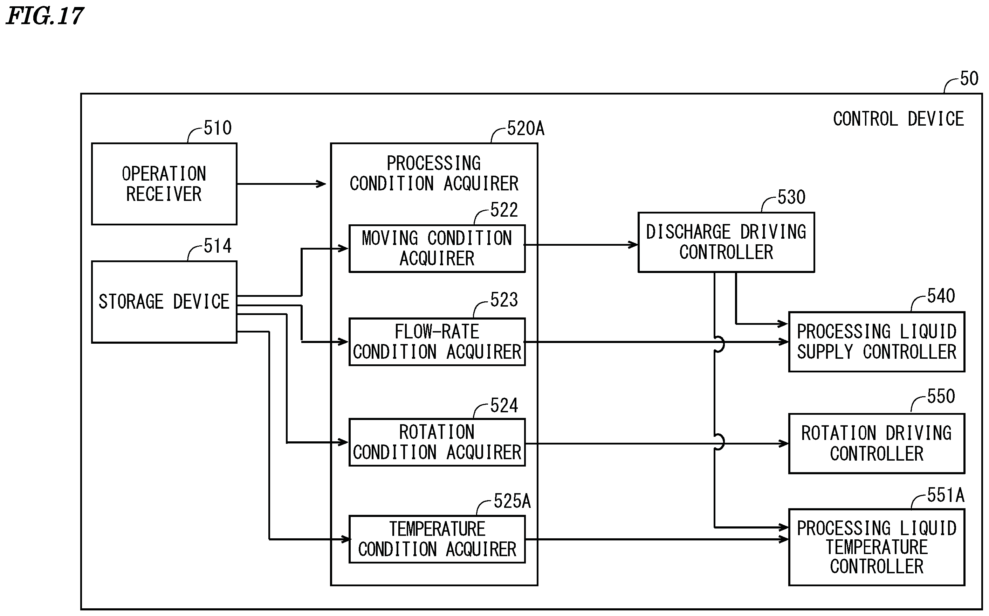

Fig. 17 is a block diagram showing one example of the functions of a control device 50 according to the third modified example. With reference to Fig. 17, the differences from the functions shown in Fig. 14 are that the temperature condition acquirer 525 is changed to a 525A, and that the processing liquid temperature controller 551 is changed to a processing liquid temperature controller 551A. The other functions shown in Fig. 17 are the same as those shown in Fig. 14. A description thereof will therefore not be repeated.

The temperature condition acquirer 525A acquires a temperature condition included in a processing condition read from the storage device 514, and outputs the acquired temperature condition to the processing liquid temperature controller 551A. The temperature condition is the information relating to a temperature of the processing liquid for each of the plurality of positions on the substrate W. Here, the temperature condition is the information that defines a heating amount of the heater 37 for each of the plurality of positions on the substrate W. The larger a set heating amount, the larger an amount of heat applied to the processing liquid by the heater 37.

The processing liquid temperature controller 551A receives the temperature condition from the temperature condition acquirer 525, and receives a relative position of the nozzle 311 with respect to the substrate W from the discharge driving controller 530. The processing liquid temperature controller 551A controls the heater 37 in accordance with the temperature condition, and the relative position of the nozzle 311 with respect to the substrate W. Specifically, the processing liquid temperature controller 551 determines a heating amount defined by the temperature condition for the relative position of the nozzle 331 with respect to the substrate W, and sets the heating amount in the heater 37. The heater 37 heats the processing liquid with an amount of heat corresponding to the set heating amount.

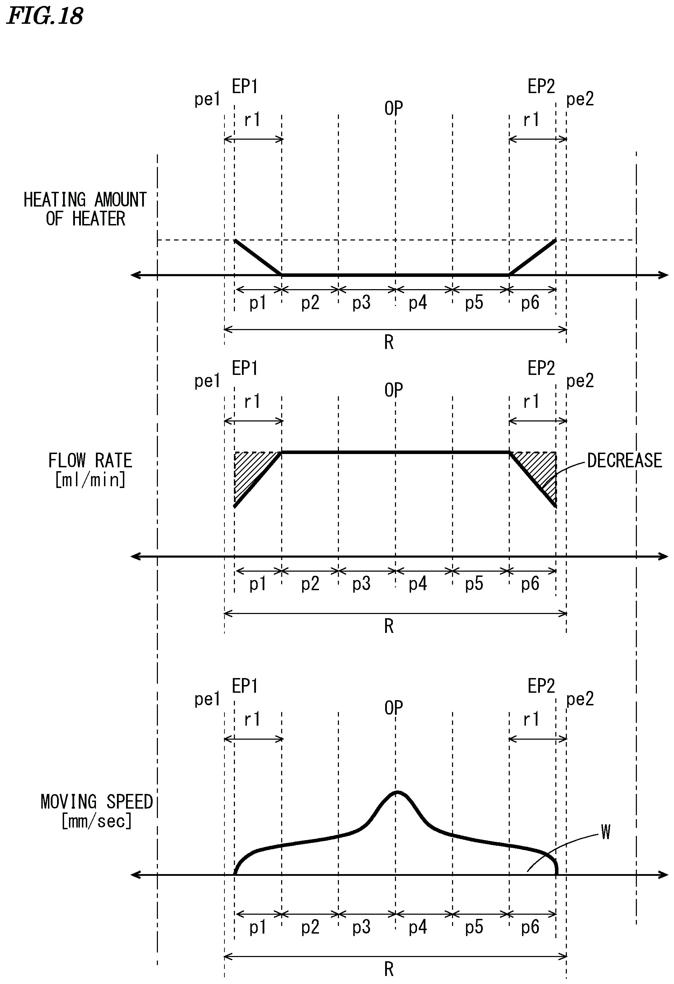

Fig. 18 is a diagram showing one example of the processing condition in the third modified example. With reference to Fig. 18, the processing condition for the six sections p1 to p6 obtained by equally dividing the substrate W into six sections in the radial direction are shown. As the processing condition, the state of the heater 37 is shown in the upper field, the flow rate of the processing liquid is shown in the middle field, and the moving speed of the nozzle 311 is shown in the lower field. The moving speed of the nozzle 311 shown in the lower field and the flow rate of the processing liquid shown in the middle field are the same as those shown in Fig. 15.

With reference to the heating amount of the heater 37 shown in the upper field, in a period during which the nozzle 311 moves above the section p1, the value of the heating amount of the heater 37 is set to decrease gradually. In a period during which the nozzle 311 is located above each of the sections p2 to p5, the heating power of the nozzle 311 is set to zero. In a period during which the nozzle 311 moves above the section p6, the value of the heating amount of the heater 37 is set to increase gradually. The temperature of the processing liquid in a period during which the nozzle 311 is located above each of the sections p1, p6 is higher than the temperature of the processing liquid in a period during which the nozzle 311 is located above each of the sections p2 to p5. In a period during which the nozzle 311 is located above each of the sections p1, p6, the closer the nozzle 311 is to the outer periphery of the substrate W in plan view, the higher the temperature of the processing liquid.

The flow rate of the processing liquid in a period during which the nozzle 311 moves above each of the sections p1, p6 is lower than the flow rate of the processing liquid in a period during which the nozzle 311 moves above each of the sections p2 to p5. In contrast, the temperature of the processing liquid in a period during which the nozzle 311 moves above each of the sections p1, p6 is higher than the temperature of the processing liquid in a period during which the nozzle 311 moves above each of the sections p2 to p5. Therefore, a processing amount of the film in the sections p1 to p6 can be made close to uniform.

In a period during which the nozzle 311 is located above each of the sections p1, p6, the closer the nozzle 311 to the outer periphery of the substrate W in plan view, the higher the temperature of the processing liquid. This causes the processing amount of the film formed on the substrate in each of the sections p1, p6 to be adjusted more precisely.

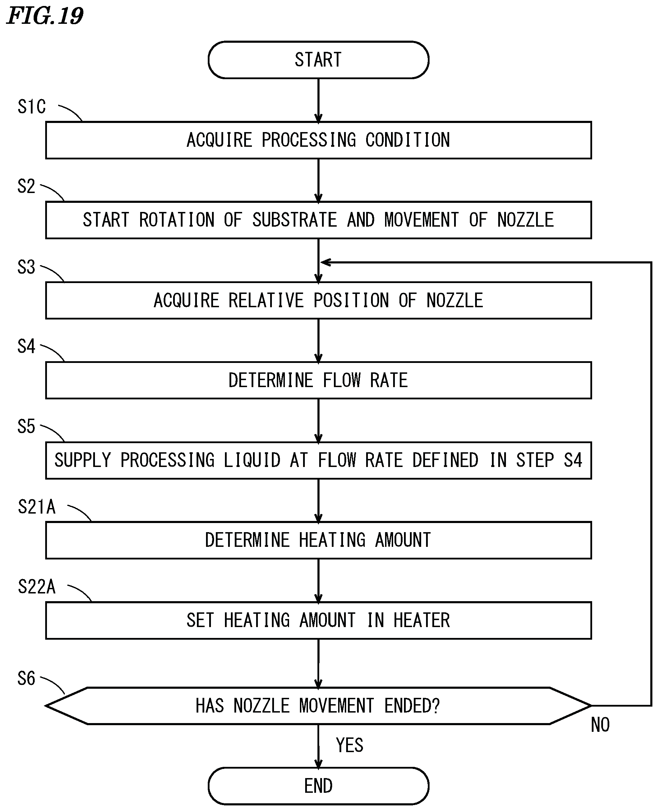

Fig. 19 is a flowchart showing one example of a flow of a film process in the third modified example. The differences of the process shown in Fig. 19 from the process shown in Fig. 9 are that the step S1 is changed to the step S1C, and the steps S21A and S22A are inserted between the steps S5 and S6. The other processes are the same as those shown in Fig. 9. A description thereof will therefore not be repeated here.

The CPU 511 acquires a processing condition (step S1C). Specifically, the CPU 511 receives processing recipe information input by the user to the device such as the keyboard, and reads, from the storage device 514, the processing condition specified by the received processing recipe information. The processing condition identified by processing condition identification information included in the processing recipe information is read from among a plurality of processing conditions stored in the storage device 514. The processing condition acquired here includes a moving condition, a flow-rate condition, and a temperature condition that are shown in Fig. 18. The temperature condition is the information that defines a heating amount of the heater 37 for each of the plurality of positions on the substrate W.

The CPU 511 determines the heating amount of the heater 37 in the step S21A. According to the temperature condition included in the processing condition acquired in the step S1B, the CPU 511 acquires the heating amount of the heater 37 defined for the position of the nozzle 311 acquired in the step S3. In the step S22A, the CPU 511 sets the heating amount in the heater 37, and the process proceeds to the step S6.

In the third modified example, for each of the plurality of sections p1 to p6, the temperature of the processing liquid is regulated in addition to the adjustment of the moving speed of the nozzle 311 and the adjustment of the flow rate of the processing liquid supplied by the nozzle 311. This facilitates adjustment of a processing amount of the film for each of the different positions arranged in the radial direction of the substrate W. Furthermore, in each of the sections p1, p6, the closer the position of the nozzle 311 to the outer periphery of the substrate W in plan view, the higher the temperature of the supplied processing liquid. This causes the processing amount of the film formed on the substrate in each of the sections p1, p6 to be adjusted more precisely. Thus, the film formed on the substrate W can be processed more efficiently.

The substrate processing apparatus 300 in the third modified example may adjust the rotation speed of the substrate W for each of the plurality of sections p1 to p6, similarly to the substrate processing apparatus 30 in the first modified example.

### (7) Fourth Modified Example

The substrate processing apparatus 300 in the above-mentioned second modified example and the substrate processing apparatus 300 in the above-mentioned third modified example regulate the temperature of the processing liquid using the heater 37. A substrate processing apparatus 300 according to a fourth modified example uses a liquid mixture of deionized water (DIW), ammonia water (NH4OH), and a hydrogen peroxide solution (H2O2) as a processing liquid, by way of example. The mixing ratio of the processing liquid is predetermined. For example, the mixing ratio of the processing liquid is 2 : 3 : 1000 (ammonia water : hydrogen peroxide solution : DIW). The substrate processing apparatus 300 in the fourth modified example regulates the temperature of the processing liquid by changing the mixing ratio of DIW having a first temperature and DIW having a second temperature different from the first temperature. The differences of the substrate processing apparatus 300 in the fourth modified example from the substrate processing apparatus 300 in the second modified example will be mainly described below.

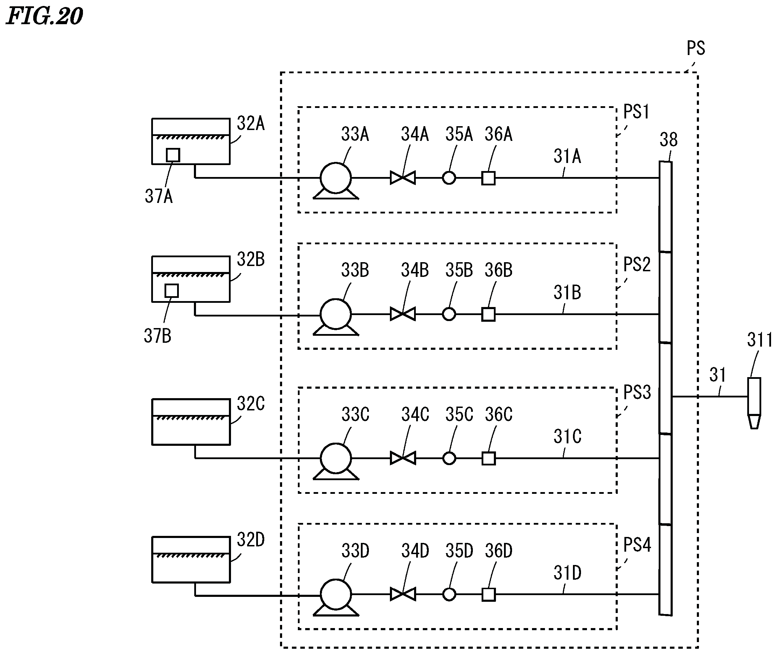

Fig. 20 is a diagram showing one example of the configuration of a processing liquid supplier included in the substrate processing apparatus in the fourth modified example. With reference to Fig. 20, the substrate processing apparatus 300 in the fourth modified example includes first to fourth storage tanks 32A to 32D.

The first storage tank 32A stores the DIW having the first temperature. A first heater 37A is provided in the first storage tank 32A. The first heater 37A heats the DIW stored in the first storage tank 32A. This maintains the temperature of the DIW stored in the first storage tank 32A at the first temperature.

The second storage tank 32B stores the DIW having the second temperature. The second temperature is lower than the first temperature. A second heater 37B is provided in the second storage tank 32B. The second heater 37B heats the DIW stored in the second storage tank 32B. This maintains the temperature of the DIW stored in the second storage tank 32B at the second temperature.

A third storage tank 32C stores ammonia water (NH4OH). The temperature of the ammonia water stored in the third storage tank 32C is room temperature. A fourth storage tank 32D stores a hydrogen peroxide solution (H2O2). The temperature of the hydrogen peroxide solution stored in the fourth storage tank 32D is room temperature.

The processing liquid supplier PS includes a first processing liquid supplier PS1, a second processing liquid supplier PS2, a third processing liquid supplier PS3, a fourth processing liquid supplier PS4, and a mixing valve 38. The first processing liquid supplier PS1 is controlled by a control device 50, and supplies the DIW having the first temperature to the nozzle 311 at a predetermined flow rate. Specifically, the first processing liquid supplier PS1 includes a first supply pipe 31A, a first supply pump 33A, a first open-close valve 34A, a first flow-rate adjustment valve 35A, and a first flow-rate sensor 36A. One end of the first supply pipe 31A is connected to the first storage tank 32A, and the other end of the first supply pipe 31A is connected to the mixing valve 38. In the first supply pipe 31A, the first supply pump 33A, the first open-close valve 34A, the first flow-rate adjustment valve 35A, and the first flow-rate sensor 36A are provided.

The second processing liquid supplier PS2 is controlled by the control device 50, and supplies the DIW having the second temperature to the nozzle 311 at a predetermined flow rate. Specifically, the second processing liquid supplier PS2 includes a second supply pipe 31B, a second supply pump 33B, a second open-close valve 34B, a second flow-rate adjustment valve 35B, and a second flow-rate sensor 36B. One end of the second supply pipe 31B is connected to the second storage tank 32B, and the other end of the second supply pipe 31B is connected to the mixing valve 38. In the second supply pipe 31B, the second supply pump 33B, the second open-close valve 34B, the second flow-rate adjustment valve 35B, and the second flow-rate sensor 36B are provided.

The third processing liquid supplier PS3 is controlled by the control device 50, and supplies the ammonia water to the nozzle 311 at a predetermined flow rate. Specifically, the third processing liquid supplier PS3 includes a third supply pipe 31C, a third supply pump 33C, a third open-close valve 34C, a third flow-rate adjustment valve 35C, and a third flow-rate sensor 36C. One end of the third supply pipe 31C is connected to the third storage tank 32C, and the other end of the third supply pipe 31C is connected to the mixing valve 38. In the third supply pipe 31C, the third supply pump 33C, the third open-close valve 34C, the third flow-rate adjustment valve 35C, and the third flow-rate sensor 36C are provided.

The fourth processing liquid supplier PS4 is controlled by the control device 50, and supplies the hydrogen peroxide solution to the nozzle 311 at a predetermined flow rate. Specifically, the fourth processing liquid supplier PS4 includes a fourth supply pipe 31D, a fourth supply pump 33D, a fourth open-close valve 34D, a fourth flow-rate adjustment valve 35D, and a fourth flow-rate sensor 36D. One end of the fourth supply pipe 31D is connected to the fourth storage tank 32D, and the other end of the fourth supply pipe 31D is connected to the mixing valve 38. In the fourth supply pipe 31D, the fourth supply pump 33D, the fourth open-close valve 34D, the fourth flow-rate adjustment valve 35D, and the fourth flow-rate sensor 36D are provided.

The first supply pipe 31A, the second supply pipe 31B, the third supply pipe 31C, the fourth supply pipe 31D, and the supply pipe 31 are connected to the mixing valve 38. An end portion of the supply pipe 31 opposite to an end portion of the supply pipe 31 connected to the mixing valve 38 is connected the nozzle 311. The mixing valve 38 mixes the DIW having the first temperature and being supplied from the first supply pipe 31A, the DIW having the second temperature and being supplied from the second supply pipe 31B, the ammonia water supplied from the third supply pipe 31C, and the hydrogen peroxide solution received from the fourth supply pipe 31D, and supplies the mixed processing liquid to the nozzle 311 via the supply pipe 31.

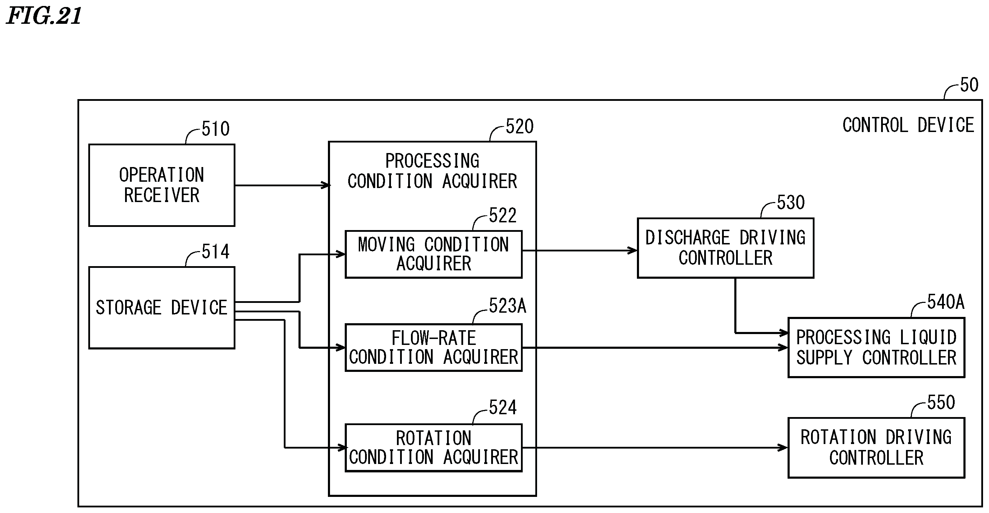

Fig. 21 is a block diagram showing one example of the functions of the control device according to the fourth modified example. With reference to Fig. 21, the differences from the functions shown in Fig. 8 are that the flow-rate condition acquirer 523 is changed to a flow-rate condition acquirer 523A, and that the processing liquid supply controller 540 is changed to a processing liquid supply controller 540A. The other functions shown in Fig. 21 are the same as those shown in Fig. 8. A description thereof will therefore not be repeated.

The flow-rate condition acquirer 523A acquires a flow-rate condition included in a processing condition read from the storage device 514, and outputs the acquired flow-rate condition to the processing liquid supply controller 540A. The flow-rate condition includes a flow rate of the DIW having the first temperature, a flow rate of the DIW having the second temperature, a flow rate of the ammonia water, and a flow rate of the hydrogen peroxide solution, for each of the plurality of positions on the substrate W. In the fourth modified example, because including the flow rate of the DIW having the first temperature and the flow rate of the DIW having the second temperature, the flow-rate condition includes a temperature condition.

Here, the flow-rate condition in the fourth modified example will be described. In the fourth modified example, the mixing ratio of the processing liquid is predetermined and constant. In the fourth modified example, the mixing ratio of the processing liquid is 2 : 3 : 1000 (ammonia water : hydrogen peroxide solution : DIW). Since the mixing ratio of the processing liquid is constant, the flow rate of the ammonia water, the flow rate of the hydrogen peroxide solution, and the flow rate of the DIW are respectively defined based on the flow rate of the processing liquid for a certain position in the radial direction of the substrate W. Because the ratio of the DIW is higher than that of the ammonia water and that of the hydrogen peroxide solution, the temperature of the processing liquid can be regarded as the temperature of the DIW. In regard to the temperature of the processing liquid for the certain position in the radial direction of the substrate W, the flow rate of the DIW having the first temperature and the flow rate of the DIW having the second temperature are defined based on the flow rate of the DIW for the position. Because the temperature of the processing liquid is defined based on the flow rate of the DIW having the first temperature and the flow rate of the DIW having the second temperature, the flow-rate condition includes the temperature condition that defines the temperature of the processing liquid.

The processing liquid supply controller 540A receives the flow-rate condition from the flow-rate condition acquirer 523A, and receives a relative position of the nozzle 311 with respect to the substrate W from the discharge driving controller 530. The processing liquid supply controller 540A controls the processing liquid supplier PS in accordance with the flow-rate condition and the relative position of the nozzle 311 with respect to the substrate W.

Specifically, the processing liquid supply controller 540A determines the flow rate of the DIW having the first temperature, with the flow rate being defined by the flow-rate condition for the relative position of the nozzle 311 with respect to the substrate W. The processing liquid supply controller 540A controls the first flow-rate adjustment valve 35A of the first processing liquid supplier PS1 to supply the DIW having the first temperature to the nozzle 311 at the determined flow rate. The processing liquid supply controller 540A determines the flow rate of the DIW having the second temperature, with the flow rate being defined by the flow-rate condition for the relative position of the nozzle 311 with respect to the substrate W. The processing liquid supply controller 540A controls the second flow-rate adjustment valve 35B of the second processing liquid supplier PS2 to supply the DIW having the second temperature to the nozzle 311 at the determined flow rate. The processing liquid supply controller 540A determines the flow rate of the ammonia water defined by the flow-rate condition for the relative position of the nozzle 311 with respect to the substrate W. The processing liquid supply controller 540A controls the third flow-rate adjustment valve 35C of the third processing liquid supplier PS3 to supply the ammonia water to the nozzle 311 at the determined flow rate. The processing liquid supply controller 540A determines the flow rate of the hydrogen peroxide solution defined by the flow-rate condition for the relative position of the nozzle 311 with respect to the substrate W. The processing liquid supply controller 540A controls the fourth flow-rate adjustment valve 35D of the fourth processing liquid supplier PS4 to supply the hydrogen peroxide solution to the nozzle 311 at the determined flow rate.

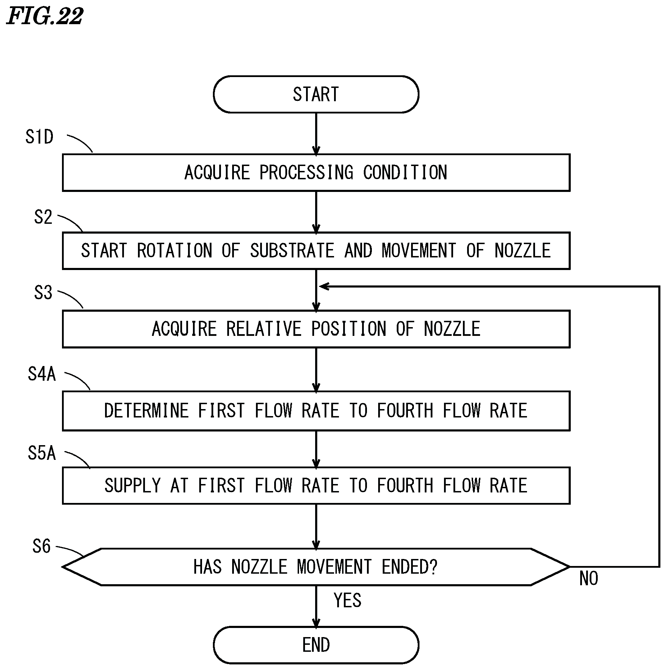

Fig. 22 is a flowchart showing one example of a flow of a film process in the fourth modified example. The differences of the process shown in Fig. 22 from the process shown in Fig. 9 are that the step S1 is changed to the step S1D, and the step S4 is changed to the step S4A, and the step S5 is changed to the step S5A. The other processes are the same as those shown in Fig. 9. A description thereof will therefore not be repeated here.

The CPU 511 acquires the processing condition (step S1D). Specifically, the CPU 511 receives processing recipe information input by the user to the device such as the keyboard, and reads, from the storage device 514, the processing condition specified by the received processing recipe information. The processing condition identified by processing condition identification information included in the processing recipe information is read from among a plurality of processing conditions stored in the storage device 514. The processing condition acquired here includes a moving condition, a flow-rate condition, and a temperature condition that are shown in Fig. 18. The flow-rate condition includes a flow rate of the DIW having the first temperature, a flow rate of the DIW having the second temperature, a flow rate of the ammonia water, and a flow rate of the hydrogen peroxide solution, for each of the plurality of positions on the substrate W. Because including the flow rate of the DIW having the first temperature and the flow rate of the DIW having the second temperature, for each of the plurality of positions on the substrate W, the flow-rate condition includes the temperature condition defining a temperature of the processing liquid for each of the plurality of positions on the substrate W.

In the step S4A, the CPU 511 determines first to fourth flow rates. The first flow rate refers to the flow rate of the DIW having the first temperature. The second flow rate refers to the flow rate of the DIW having the second temperature. The third flow rate refers to the flow rate of the ammonia water. The fourth flow rate refers to the flow rate of the hydrogen peroxide solution. According to the flow-rate condition included in the processing condition acquired in the step S1D, the CPU 511 acquires the first to fourth flow rates defined for the position of the nozzle 311 acquired in the step S3. In the step S5A, the CPU 511 supplies the DIW having the first temperature at the first flow rate, the DIW having the second temperature at the second flow rate, the ammonia water at the third flow rate, and the hydrogen peroxide solution at the fourth flow rate, and the process proceeds to the step S6.

In the fourth modified example, the temperature of the processing liquid is regulated by changing the flow rate of the DIW having the first temperature and the flow rate of the DIW having the second temperature. In the fourth modified example, in addition to the effects of the third modified example, the temperature of the processing liquid can be easily regulated.

### (8) Fifth Modified Example

With the substrate processing apparatus 300 in the above-mentioned first embodiment, the moving speed of the nozzle 311 and the flow rate of the processing liquid supplied to the nozzle 311 are adjusted for each of the plurality of different positions arranged on the substrate W in the radial direction of the substrate W. In a fifth modified example, the substrate processing apparatus 300 in the first embodiment further adjusts the mixing ratio of the processing liquid for each of the plurality of positions arranged on the substrate W in the radial direction of the substrate W. The differences of the substrate processing apparatus 300 in the fifth modified example from the substrate processing apparatus 300 in the first embodiment will be mainly described below. In the fifth modified example, a sulfuric acid hydrogen peroxide mixture (SPM) is used as the processing liquid, by way of example.

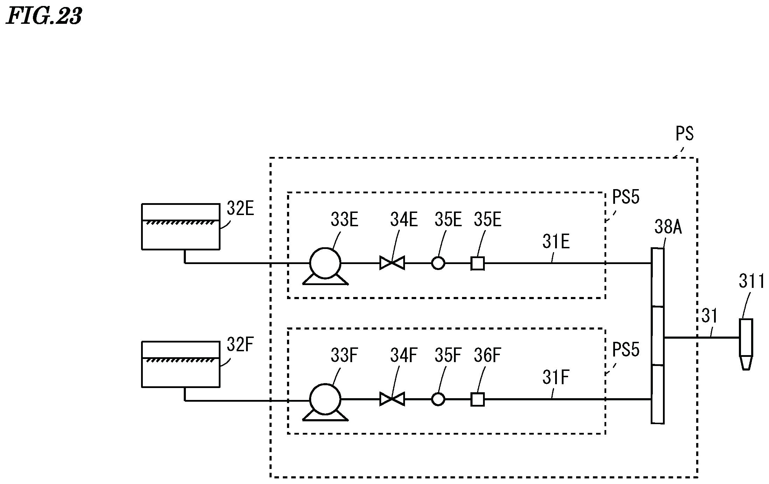

Fig. 23 is a diagram showing one example of the configuration of a processing liquid supplier PS included in the substrate processing apparatus in the fifth modified example. With reference to Fig. 23, the substrate processing apparatus 300 in the fifth modified example includes a fifth storage tank 32E and a sixth storage tank 32F. The fifth storage tank 32E stores a first processing liquid. The first processing liquid is sulfuric acid (H2SO4). The sixth storage tank 32F stores a second processing liquid. The second processing liquid is a hydrogen peroxide solution (H2O2).

The processing liquid supplier PS includes a fifth processing liquid supplier PS5, a sixth processing liquid supplier PS6, and a mixing valve 38A. The fifth processing liquid supplier PS5 is controlled by a control device 50, and supplies the sulfuric acid to the nozzle 311 at a predetermined flow rate. Specifically, the fifth processing liquid supplier PS5 includes a fifth supply pipe 31E, a fifth supply pump 33E, a fifth open-close valve 34E, a fifth flow-rate adjustment valve 35E, and a fifth flow-rate sensor 36E. One end of the fifth supply pipe 31E is connected to the fifth storage tank 32E, and the other end of the fifth supply pipe 31E is connected to the mixing valve 38A. In the fifth supply pipe 31E, the fifth supply pump 33E, the fifth open-close valve 34E, the fifth flow-rate adjustment valve 35E, and the fifth flow-rate sensor 36E are provided.

The sixth processing liquid supplier PS6 is controlled by the control device 50, and supplies the hydrogen peroxide solution to the nozzle 311 at a predetermined flow rate. Specifically, the sixth processing liquid supplier PS6 includes a sixth supply pipe 31F, a sixth supply pump 33F, a sixth open-close valve 34F, a sixth flow-rate adjustment valve 35F, and a sixth flow-rate sensor 36F. One end of the sixth supply pipe 31F is connected to the sixth storage tank 32F, and the other end of the sixth supply pipe 31F is connected to the mixing valve 38A. In the sixth supply pipe 31F, the sixth supply pump 33F, the sixth open-close valve 34F, the sixth flow-rate adjustment valve 35F, and the sixth flow-rate sensor 36F are provided.

The fifth supply pipe 31E, the sixth supply pipe 31F, and the supply pipe 31 are connected to the mixing valve 38A. An end portion of the supply pipe 31 opposite to an end portion of the supply pipe 31 connected to the mixing valve 38 is connected to the nozzle 311. The mixing valve 38A mixes the sulfuric acid supplied from the fifth supply pipe 31E and the hydrogen peroxide solution supplied from the sixth supply pipe 31F, and supplies the mixed SPM to the nozzle 311 via the supply pipe 31.

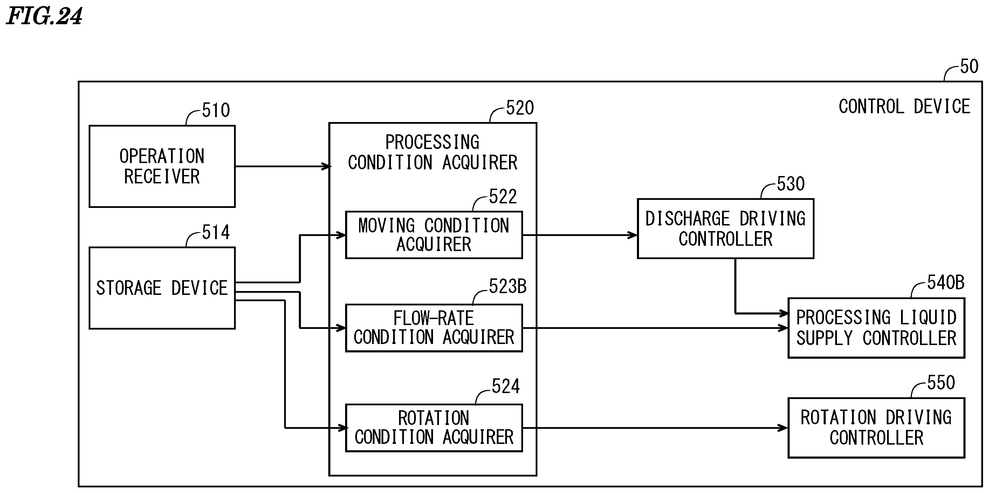

Fig. 24 is a block diagram showing one example of the functions of the control device 50 according to the fifth modified example. With reference to Fig. 24, the differences from the functions shown in Fig. 8 are that the flow-rate condition acquirer 523 is changed to a flow-rate condition acquirer 525B, and that the processing liquid supply controller 540 is changed to a processing liquid supply controller 540B. The other functions shown in Fig. 24 are the same as those shown in Fig. 8. A description thereof will therefore not be repeated.

The flow-rate condition acquirer 523B acquires a flow-rate condition included in the processing condition read from the storage device 514, and outputs the acquired flow-rate condition to the processing liquid supply controller 540B. The flow-rate condition includes a flow rate of the sulfuric acid and a flow rate of the hydrogen peroxide solution for each of the plurality of positions on the substrate W. In the fifth modified example, the flow-rate condition includes the flow rate of the sulfuric acid and the flow rate of the hydrogen peroxide solution. The ratio of the flow rates coincides with the mixing ratio of the sulfuric acid and the hydrogen peroxide. Therefore, the flow-rate condition indicates the mixing ratio of the SPM.

The processing liquid supply controller 540B receives the flow-rate condition from the flow-rate condition acquirer 523B, and receives the relative position of the nozzle 311 with respect to the substrate W from the discharge driving controller 530. The processing liquid supply controller 540A controls the processing liquid supplier PS in accordance with the flow-rate condition, and the relative position of the nozzle 311 with respect to the substrate W.

Specifically, the processing liquid supply controller 540B determines the flow rate of the sulfuric acid defined by the flow-rate condition for the relative position of the nozzle 311 with respect to the substrate W. The processing liquid supply controller 540B controls the fifth flow-rate adjustment valve 35E of the fifth processing liquid supplier PS5 to supply the sulfuric acid to the nozzle 311 at the determined flow rate. The processing liquid supply controller 540B determines the flow rate of the hydrogen peroxide solution defined by the flow-rate condition for the relative position of the nozzle 311 with respect to the substrate W. The processing liquid supply controller 540B controls the sixth flow-rate adjustment valve 35F of the sixth processing liquid supplier PS6 to supply the hydrogen peroxide solution to the nozzle 311 at the determined flow rate.

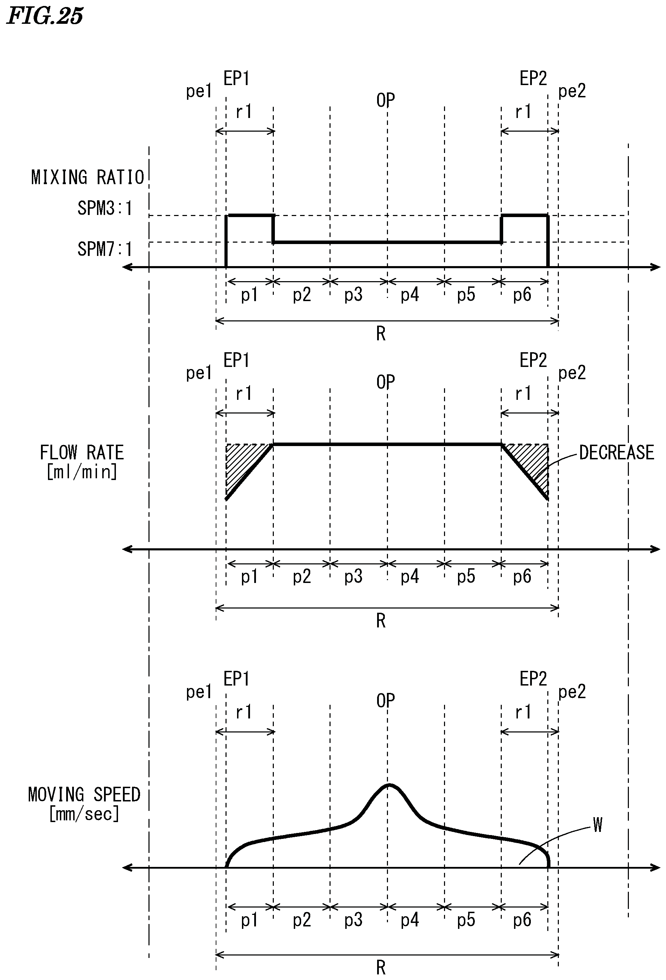

Fig. 25 is a diagram showing one example of the processing condition in the fifth modified example. With reference to Fig. 25, the processing condition for the six sections p1 to p6 is shown. As the processing condition, the mixing ratio of the SMP is shown in the upper field, the flow rate of the processing liquid is shown in the middle field, and the moving speed of the nozzle 311 is shown in the lower field. The moving speed of the nozzle 311 shown in the lower field and the flow rate of the processing liquid shown in the middle field are the same as those shown in Fig. 15.

With reference to the mixing ratio of the SMP shown in the upper field, in a period during which the nozzle 311 moves above each of the sections p1, p6, the mixing ratio of the SPM is set to 3 : 1 (sulfuric acid : hydrogen peroxide solution). In a period during which the nozzle 311 is located above each of the sections p2 to p5, the mixing ratio of the SPM is set to 7 : 1 (sulfuric acid : hydrogen peroxide solution).

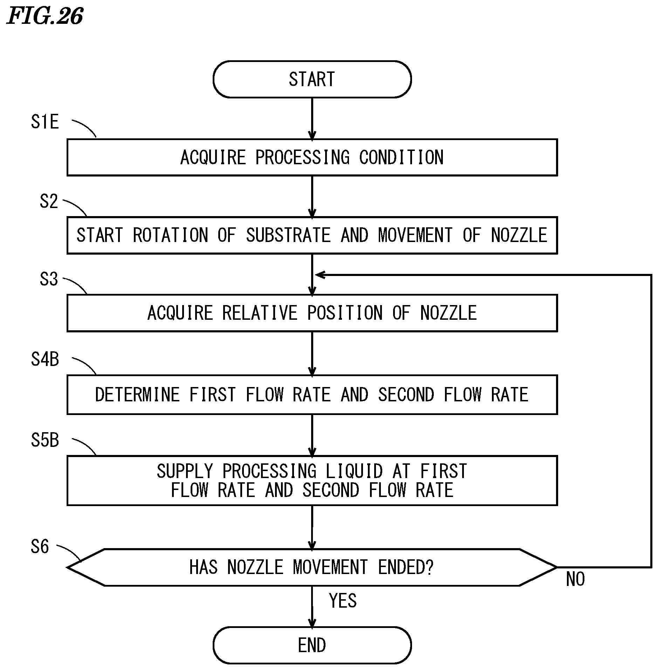

Fig. 26 is a flowchart showing one example of a flow of a film process in the fifth modified example. The differences of the process shown in Fig. 26 from the process shown in Fig. 9 are that the step S1 is changed to the step S1E, and the step S4 is changed to the step S4B, and the step S5 is changed to the step S5B. The other processes are the same as those shown in Fig. 9. A description thereof will therefore not be repeated here.

The CPU 511 acquires the processing condition (step S1E). Specifically, the CPU 511 receives processing recipe information input by the user to the device such as the keyboard, and reads, from the storage device 514, the processing condition specified by the received processing recipe information. The processing condition identified by processing condition identification information included in the processing recipe information is read from among a plurality of processing conditions stored in the storage device 514. The processing condition acquired here includes the moving condition and the flow-rate condition that are shown in Fig. 25. The flow-rate condition includes the flow rate of the sulfuric acid and the flow rate of the hydrogen peroxide solution for each of the plurality of positions on the substrate W. Since the ratio of the flow rates of the sulfuric acid and the hydrogen peroxide solution coincides with the mixing ratio of the SPM, the flow-rate condition includes a mixing ratio condition that defines the mixing ratio of the processing liquid for each of the plurality of positions on the substrate W.

In the step S4A, the CPU 511 determines a first flow rate and a second flow rate. The first flow rate refers to the flow rate of the sulfuric acid. The second flow rate refers to the flow rate of the hydrogen peroxide solution. According to the flow-rate condition included in the processing condition acquired in the step S1E, the CPU 511 acquires the first flow rate and the second flow rate that are defined for the position of the nozzle 311 acquired in the step S3. In the step S5B, the CPU 511 supplies the sulfuric acid at the first flow rate and the hydrogen peroxide solution at the second flow rate, and then the process proceeds to the step S6.

In the fifth modified example, the flow rate and the mixing ratio of the SPM are adjusted by changing the flow rate of the sulfuric acid and the flow rate of the hydrogen peroxide solution. In the fifth modified example, in addition to the effects of the third modified example, the mixing ratio of the processing liquid can be easily adjusted.

While the moving speed of the nozzle 311, the flow rate of the processing liquid, and the mixing ratio of the processing liquid vary for each of the plurality of positions on the substrate W in the fifth modified example, the temperature of the processing liquid may also vary similarly to the third and fourth modified examples.

### <Second Embodiment>

While the plurality of processing conditions are stored in the storage device 514 in the above-mentioned embodiment, the present invention is not limited to this. For example, the control device 50 may include an inference model for inferring a processing condition. The inference model is generated by causing a learning model to execute machine learning using training data.

The training data, which the learning model learns in machine learning, includes an explanatory variable and an objective variable. The explanatory variable is a processing amount indicating the difference between film thicknesses obtained before and after the substrate processing apparatus 300 executes a film process on the substrate W. The objective variable is the data as a processing condition for the film process executed by the substrate processing apparatus 300. The processing amount is a value shown as an example in Fig. 2. The processing condition includes the moving condition shown as an example in Fig. 5, the flow-rate condition shown as an example in Fig. 6, and the rotation condition shown as an example in Fig. 11.

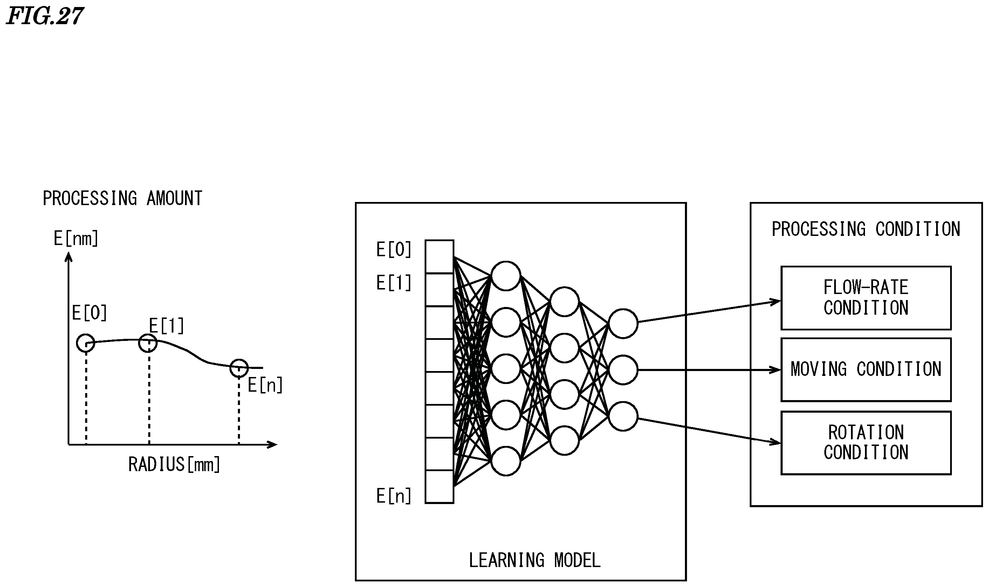

Fig. 27 is a diagram showing one example of the learning model. With reference to Fig. 27, the learning model is a neural network including nodes in a plurality of layers, for example. The inference model is generated by causing the learning model to execute machine learning using the training data.

Each layer includes a plurality of nodes indicated by white circles. While one intermediate layer is shown in the diagram, the number of intermediate layers may be larger than one. Although five nodes are shown in an input layer, four nodes are shown in an intermediate layer, and three nodes are shown in an output layer, the numbers of nodes in respective layers are not limited to these. The output of an upper node is connected to the input of a lower node. Parameters include a coefficient for weighting the output of the upper node. Further, the number of intermediate layers is equal to or larger than one, and not limited. A processing amount is represented by the difference E[n] between the film thicknesses obtained before and after the process at each of the plurality of positions P[n] (n is an integer equal to or larger than one) arranged in the radial direction of the substrate W.

A plurality of training data pieces are obtained in advance by an experiment or the like. The learning model shown in Fig. 13 executes machine learning using the plurality of training data pieces, so that the inference model is generated. Here, for example, an explanatory variable is input to the neural network as input data, and parameters of the neural network are determined such that the output of the neural network is equal to ground truth data, which is an objective variable. A neural network incorporating the parameters set in the trained neural network is generated as the inference model. The inference model is an inference program incorporating the parameters set in the trained neural network.

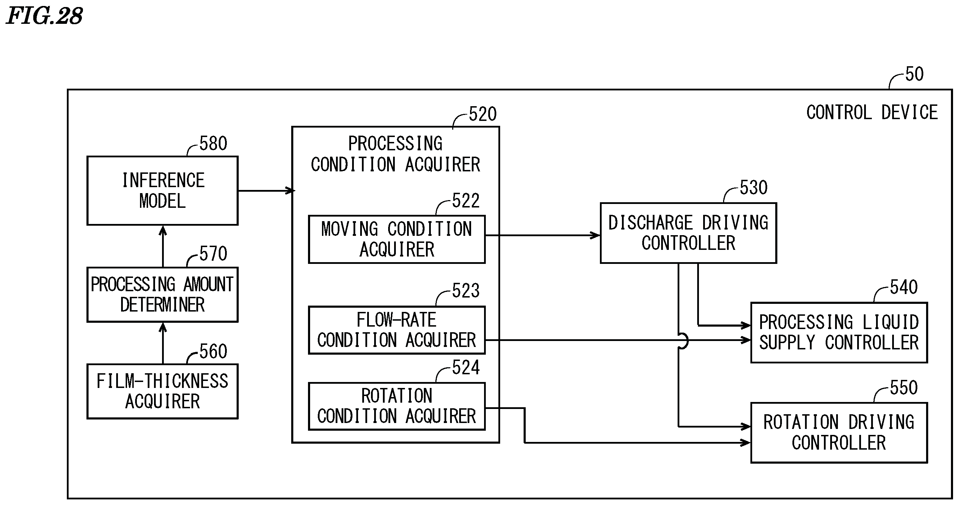

Fig. 14 is a block diagram showing one example of the functional configuration of the control device 50 in the second modified example. With reference to Fig. 28, the differences from the functions shown in Fig. 8 are that a film-thickness acquirer 560, a processing amount determiner 570, and an inference model 580 are added. The other functions are the same as those shown in Fig. 8. A description thereof will therefore not be repeated.

The film-thickness acquirer 560 acquires a thickness of a film that is formed on the substrate W and to be processed by the substrate processing apparatus 300. Here, the film thickness is measured by a sensor, for measuring a film thickness, included in the substrate processing apparatus 300, for example. A laser beam is emitted toward the obverse surface of the substrate W, the laser beam is received by a line sensor, and the film thickness is measured based on the intensity of the received laser beam, for example. Thus, the film-thickness acquirer 560 acquires the thickness of the film formed on the substrate W before the film process is executed.

The processing amount determiner 570 determines a processing amount for the film process based on the film thickness acquired by the film-thickness acquirer 560. Here, the difference between a target film-thickness and the film thickness acquired by the film-thickness acquirer 560 is determined as the processing amount. The processing amount determined by the processing amount determiner 570 is an example of a second processing amount.

The inference model 580 receives the second processing amount from the processing amount determiner 570. The inference model 580 infers a processing condition in response to receiving the second processing amount, and outputs the inferred processing condition to the processing condition acquirer 520. The processing condition acquirer 520 acquires the processing condition from the inference model 580.

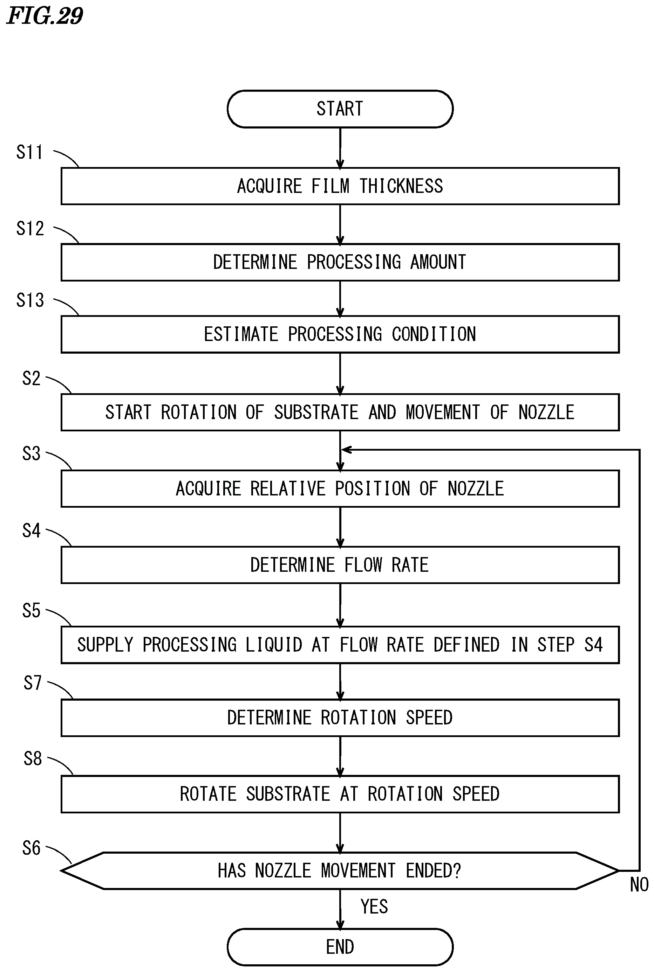

Fig. 29 is a flowchart showing a flow of the film process in the second embodiment. The process shown in Fig. 29 is different from the film process in the first modified example shown in Fig. 12 in that the step S1A is changed to the steps S11 and S12. The other processes are the same as those shown in Fig. 12. A description thereof will therefore not be repeated here.

In the step S11, the CPU 511 acquires a film thickness. The CPU 511 controls the sensor to measure the thickness of the film that is formed on the substrate W and to be processed, thereby acquiring the film thickness. In the next step S12, the CPU 511 determines a processing amount. The CPU 511 determines the processing amount based on the film thickness acquired in the step S11 and a target film-thickness. The processing amount determined here is the second processing amount.

In the next step S13, the CPU 511 estimates the processing condition using the inference model, and the process proceeds to the step S2. The CPU 511 provides the processing amount determined in the step S12 to the inference model, and causes the inference model to make an inference. The CPU 511 acquires the processing condition inferred by the inference model.

In the step S4, a flow rate is determined based on a flow-rate condition included in the processing condition inferred in the step S13. Further, in the step S7, a rotation speed is determined based on a rotation condition included in the processing condition inferred in the step S13.

Because the substrate processing apparatus 300 in the second embodiment infers the processing condition using the inference model, an appropriate processing condition can be easily obtained from among complicated combinations of the moving condition, the flow-rate condition, and the rotation condition.

In the second embodiment, the training data to be used for machine learning executed by the learning model includes, as objective variables, the moving condition shown as one example in Fig. 5, the flow-rate condition shown as one example in Fig. 6, and the rotation condition shown as one example in Fig. 11. In regard to the flow-rate condition shown as one example Fig. 6, the flow rate for each of the sections p1, p6 with the nozzle 311 being located above the divided area b1, which is the peripheral portion of the substrate W, is lower than the flow rate for each of the other sections p2 to p5. Further, in regard to the rotation condition shown as one example in Fig. 11, the rotation speed for each of the sections p1, p6 with the nozzle 311 being located above the divided area b1, which is the peripheral portion of the substrate W, is lower than the rotation speed for each of the other sections p2 to p5. Therefore, similar conditions are also likely to be inferred by the inference model in regard to the flow-rate condition and the rotation condition, with the inference model being generated when the learning model executes machine learning using the training data. In regard to the flow-rate condition, the inference is likely to indicate that the flow rate of the processing liquid in a case in which the nozzle 311 is located above each of the sections p1, p6 is lower than the flow rate of the processing liquid in a case in which the nozzle 311 is located above each of the other sections p2 to p5. Further, in regard to the rotation condition, the inference is likely to indicate that the rotation speed in a case in which the nozzle 311 is located above each of the sections p1, p6 is lower than the rotation speed in a case in which the nozzle 311 is located above each of the other sections p2 to p5.

### Modified Example of Second Embodiment

In the above-mentioned embodiment, the plurality of processing conditions are stored in advance in the storage device 514. A substrate processing apparatus 300 in a modified example of the second embodiment generates a plurality of processing conditions using the inference model used in the second embodiment, and stores the plurality of generated processing conditions in the storage device 514. In this case, because the plurality of processing conditions for generating the inference model are simply required to be obtained by an experiment or the like, the processing conditions the number of which is larger than the number of experiments can be stored in the storage device 514.

### < Other Embodiments >

(i) In the above-mentioned first embodiment, the processing condition specified by the processing condition identification information included in the processing recipe information input by the user and received by the operation receiver 510 is read from the storage device 514, by way of example. However, the present invention is not limited to this. Out of the plurality of processing conditions stored in the storage device 514, a processing condition corresponding to the substrate W to be processed by the substrate processing apparatus 300 is simply required to be acquired. For example, a processing condition may be specified by a lot number of the substrate W or an FOUP number for storage of the substrate W. Alternatively, a processing condition may be specified based on substrate identification information for identifying the substrate W.
(ii) In the above-mentioned first embodiment, in regard to the flow-rate condition, the flow rate for an area spaced apart from the outer peripheral end of the substrate by a predetermined distance is lower than the flow rates for the other areas. However, the present invention is not limited to this. In regard to the flow-rate condition, the flow rate for the area spaced apart from the outer peripheral end of the substrate by the predetermined distance may be equal to or higher than the flow rates for the other areas. The control device 50 controls the discharge driving controller 530 according to the flow-rate condition stored in the storage device 514, and causes the processing liquid to be discharged from the nozzle 311. In this case, an etching amount for the peripheral portion of the substrate W can be increased. In a case in which a thick film is formed on the peripheral portion, the uniformity of etching in the surface of the substrate W can be improved.
(iii) In the above-mentioned first embodiment, the moving speed of the nozzle 311 for each of the work end portions EP1, EP2 is set to zero, by way of example. However, the position for which the moving speed of the nozzle 311 is set to zero is not limited to this. The moving speed of the nozzle may be set to zero for any position on the trajectory of the nozzle 311, for example. Any period can be set as a period during which the moving speed is zero. It is possible to improve the uniformity of etching in the surface of the substrate W by setting the moving speed for a position other than the work end portions EP1, EP2 to zero.
(iv) In the first modified example, in regard to the rotation condition, the rotation speed for an area spaced apart from the outer peripheral end of the substrate by the predetermined distance is lower than the rotation speeds for the other areas. However, the present invention is not limited to this. In regard to the rotation condition, the rotation speed for an area spaced apart from the outer peripheral end of the substrate by the predetermined distance may be higher than the rotation speeds for the other areas. In particular, in a case in which the discharge port for discharging the processing liquid is a spray-type nozzle for spraying the processing liquid onto the substrate W, a liquid film of the processing liquid is thin. Therefore, the energy of water droplets is easily transmitted to the film, and the frequency of the processing liquid coming into contact with the film increases. This can increase an amount of the film to be removed.
   Further, in regard to the rotation condition, different rotation speeds may be defined for the plurality of positions. In short, the discharge driving controller 530 controls the spin motor SM according to the rotation condition stored in the storage device 514, and causes the substrate W to rotate at a rotation speed defined by the rotation condition. In this case, the uniformity of etching in the surface of the substrate W can be improved.
(v) In the description of the first modified example, in regard to the rotation condition, the rotation speed in a case in which the nozzle 311 is located above each of the sections p1, p6 is defined to be lower than the rotation speed in a case in which the nozzle 311 is located above each of the other sections p2 to p5. Further, in the description of the flow-rate condition, the flow rate of the processing liquid in a case in which the nozzle 311 is located above each of the sections p1, p6 is defined to be lower than the flow rate of the processing liquid in a case in which the nozzle 311 is located above each of the other sections p2 to p5. The section for which the rotation speed of the substrate is low may be different from the section for which the flow rate of the processing liquid is low. For example, the rotation speed of the substrate W for a first annular area spaced apart from the outer periphery of the substrate W by a first distance may be lower than the rotation speeds of the substrate W for the other areas. The flow rate of the processing liquid for a second annular area spaced apart from the outer periphery of the substrate W by a second distance different from the first distance may be lower than use of the processing liquid for the other areas. In this case, it is possible to prevent the processing liquid from splashing to the peripheral portion of the substrate W while improving the uniformity of etching in the surface of the substrate W.
(vi) In the second to fourth modified examples, in regard to the temperature condition, the temperature of the processing liquid for an area spaced apart from the outer peripheral end of the substrate by the predetermined distance is higher than the temperatures of the processing liquid for the other areas. However, the present invention is not limited to this. In the temperature condition, the temperature of the processing liquid for an area spaced apart from the outer peripheral end of the substrate by the predetermined distance may be equal to or lower than the temperatures of the processing liquid for the other areas. In this case, an etching amount in the peripheral portion of the substrate W can be reduced. In a case in which a thin film is formed on the peripheral portion, the uniformity of etching in the surface of the substrate W can be improved.
   While, in the temperature condition, the flow rate of the processing liquid having the first temperature and the flow rate of the processing liquid having the second temperature are defined in the fourth modified example, only the temperature of the processing liquid may be defined. The first flow rate of the DIW having the first temperature, the second flow rate of the DIW having the second temperature, the third flow rate of the ammonia water, and the fourth flow rate of the hydrogen peroxide solution are defined based on the flow rate and the temperature of the processing liquid. In this case, only temperatures may be defined in the temperature condition.
(vii) In the description of the second embodiment, in the training data used in machine learning executed by the learning model, in regard to the flow-rate condition serving as a target variable, the flow rate for each of the sections p1, p6 with the nozzle 311 being located above the divided area b1, which is the periphery portion of the substrate W, is lower than the flow rates for the other sections p2 to p5. In regard to the rotation condition, the rotation speed for each of the sections p1, p6 with the nozzle 311 being located above the divided area b1, which is the peripheral portion of the substrate W, is lower than the rotation speeds for the other sections p2 to p5. However, the present invention is not limited to this.

In the training data used in machine learning executed by the learning model, any values can be used for the flow-rate condition and the rotation condition, which serve as target variables. Further, as the flow-rate condition, the flow rate for each of the sections p1, p6 with the nozzle 311 being located above the divided area b1, which is the peripheral portion of the substrate W, may be higher than the flow rates for the other sections p2 to p5. In regard to the rotation condition, the rotation speed for each of the sections p1, p6 with the nozzle 311 being located above the divided area b1, which is the peripheral portion of the substrate W, may be higher than the rotation speeds for the other sections p2 to p5.

In the training data used for machine learning executed by the learning model, at least one of the rotation condition, the temperature condition, and the mixing ratio condition may be added as a target variable in addition to the moving condition and the flow-rate condition.

### < Correspondences Between Constituent Elements in Claims and Parts in Preferred Embodiments >

The spin chuck SC and the spin motor SM are examples of a rotation driver, the nozzle 311 is an example of a discharger, the processing liquid supplier PS is an example of a processing liquid supplier, the nozzle motor 303 is an example of a discharge driver, the control device 50 is an example of a controller, the divided area b1 is an example of a peripheral area, and the inference model 580 is an example of an inference model. The supply pipe 31 is an example of a supply pipe, and the heater 37 is an example of a heater. In the fourth modified example, the DIW having the first temperature is an example of a first processing liquid, the DIW having the second temperature is an example of a second processing liquid, the first processing liquid supplier PS1 is an example of a first processing liquid supplier, the second processing liquid supplier PS2 is an example of a second processing liquid supplier, the first flow-rate adjustment valve 35A is an example of a first processing liquid flow-rate adjuster, the second flow-rate adjustment valve 35B is an example of a second processing liquid flow-rate adjuster, and the mixing valve 38 is an example of a mixer. In the fifth modified example, the SPM is an example of a processing liquid, the sulfuric acid is an example of a first processing liquid, the hydrogen peroxide solution is an example of a second processing liquid, the fifth processing liquid supplier PS5 is an example of a first processing liquid supplier, the sixth processing liquid supplier PS6 is an example of a second processing liquid supplier, the fifth flow-rate adjustment valve 35E is an example of a first processing liquid flow-rate adjuster, the sixth flow-rate adjustment valve 35F is an example of a second processing liquid flow-rate adjuster, and the mixing valve 38A is an example of a mixer.

### < Overview of Embodiments >

(Item 1) A substrate processing apparatus according to one aspect of the present invention that processes a film by supplying a processing liquid to a substrate on which the film is formed, includes a rotation driver that rotates the substrate while holding the substrate, a discharger that discharges the processing liquid, a processing liquid supplier that supplies the processing liquid to the discharger, a discharge driver that moves the discharger to positions above a plurality of different positions on the substrate held by the rotation driver, the plurality of different positions being arranged in a radial direction of the substrate, and a controller that controls the processing liquid supplier and the discharge driver in accordance with a processing condition, wherein the processing condition includes a moving condition that defines a moving speed of the discharger for each of the plurality of positions, and a flow-rate condition that defines, for each of the plurality of positions, a flow rate of the processing liquid supplied to the discharger.

With the substrate processing apparatus according to item 1, the moving speed of the discharger and the flow rate of the processing liquid supplied to the discharger are adjusted for each of the plurality of different positions arranged on the substrate in the radial direction of the substrate. This enables the film formed on the substrate to be efficiently processed. Thus, it is possible to provide the substrate processing apparatus capable of reducing the consumption of the processing liquid for processing the film formed on the substrate.

(Item 2) The substrate processing apparatus according to item 1, wherein in the flow-rate condition, a flow rate of the processing liquid in a case in which a position of the discharger is above a peripheral area located within a predetermined distance from a periphery of the substrate may be defined to be lower than a flow rate of the processing liquid in a case in which the position of the discharger is above an area other than the peripheral area.

With the substrate processing apparatus according to item 2, when the discharger is located above the peripheral area, the flow rate of the processing liquid discharged from the discharger is reduced. This suppresses splashing, outwardly of the substrate, of the processing liquid that has been supplied to the substrate.

(Item 2-1) The substrate processing apparatus according to item 2, wherein a moving range in which the discharge driver moves the discharger may be defined based on a flow rate of the processing liquid supplied by the processing liquid supplier.

With the substrate processing apparatus according to item 2-1, the moving range in which the discharge driver moves the discharger is defined by the flow rate of the processing liquid. In this case, when the processing liquid that has been discharged from the discharger impinges on the substrate, the processing liquid spreads from the position of impingement to the surrounding area. The lower the flow rate, the smaller an amount of spreading of the processing liquid. When an amount of spreading of the processing liquid is reduced, the position at which the processing liquid impinges on the substrate can be brought closer to the outside of the substrate. Therefore, the film can be efficiently processed.

(Item 2-2) The substrate processing apparatus according to item 2, wherein the moving condition may include a condition in which a moving speed of the discharger is zero for a predetermined period of time above any one of the plurality of positions.

With the substrate processing apparatus according to item 2-2, because the movement of the discharger is stopped above any one of the plurality of positions, an amount of the processing liquid supplied to the position above which the discharger is stopped can be increased. Therefore, the processing amount in the film process can be partially varied.

(Item 2-3) The substrate processing apparatus according to item 2, wherein the moving condition may include a value that causes a moving direction of the discharger to be reversed at least once.

With the substrate processing apparatus according to item 2-3, because the direction in which the discharger moves is reversed, the processing liquid can be supplied to a plurality of positions multiple times.

(Item 2-4) The substrate processing apparatus according to item 2, wherein the processing condition may further include a rotation condition that defines a rotation speed at which the substrate is rotated for each of the plurality of positions, and the controller may control the rotation driver in accordance with the rotation condition.

With the substrate processing apparatus according to item 2-4, the substrate is rotated at different rotation speeds at the plurality of positions. This can facilitate adjustment of an amount of processing liquid to be supplied per unit area to different positions arranged in the radial direction of the substrate.

(Item 2-5) The substrate processing apparatus according to item 2-4, wherein in the rotation condition, a value of a rotation speed of the substrate in a case in which a discharge port is located above a peripheral area may be defined to be higher than a rotation speed of the substrate in a case in which the discharger is located above an area other than the peripheral area.

With the substrate processing apparatus according to item 2-5, when the discharger is located above the peripheral area, the rotation speed of the substrate is low. This suppresses splashing, outwardly of the substrate, of the processing liquid that has been supplied to the substrate.

(Item 3) The substrate processing apparatus according to item 1, wherein the processing condition may further include a rotation condition in which a rotation speed at which the substrate is rotated is defined for each of the plurality of positions.

With the substrate processing apparatus according to item 3, in addition to the adjustment of the moving speed of the discharger and the adjustment of the flow rate of the processing liquid supplied by the discharger, for each of the plurality of positions, the rotation speed at which the substrate is rotated can be adjusted for each of the plurality of positions. This enables the film formed on the substrate to be efficiently processed.

(Item 4) The substrate processing apparatus according to any one of items 1 to 3, wherein the processing condition further includes a temperature condition relating to a temperature, for each of the plurality of positions, of the processing liquid discharged from the discharger to the substrate, and the controller controls the processing liquid supplier to regulate a temperature of the processing liquid discharged from the discharger to the substrate.

With the substrate processing apparatus according to item 4, the temperature of the processing liquid for each of the plurality of different positions arranged on the substrate in the radial direction of the substrate is regulated. The temperature of the processing liquid and the processing amount have a predetermined correlation. This enables the film formed on the substrate to be more efficiently processed.

(Item 5) The substrate processing apparatus according to claim 4, wherein the processing liquid supplier includes a supply pipe that supplies the processing liquid to the discharger, and a heater that is provided in the supply pipe and heats the processing liquid.

With the substrate processing apparatus according to item 5, the heater that heats the processing liquid is provided in the supply pipe that supplies the processing liquid to the discharger. This enables easy regulation of the temperature of the processing liquid discharged from the discharger.

(Item 6) The substrate processing apparatus according to any one of items 1 to 3, wherein the processing condition further includes a mixing ratio condition relating to a mixing ratio, for each of the plurality of positions, of the processing liquid discharged from the discharger to the substrate, and the controller controls the processing liquid supplier to adjust the mixing ratio of the processing liquid discharged from the discharger to the substrate.

With the substrate processing apparatus according to item 6, the mixing ratio of the processing liquid for each of the plurality of different positions arranged on the substrate in the radial direction of the substrate is adjusted. The mixing ratio of the processing liquid and the processing amount have a predetermined correlation. This enables the film formed on the substrate to be more efficiently processed.

(Item 7) The substrate processing apparatus according to item 6, wherein the processing liquid supplier includes a first processing liquid supplier that supplies a first processing liquid to the discharger, a second processing liquid supplier that supplies a second processing liquid to the discharger, a first processing liquid flow-rate adjuster that adjusts a flow rate of the first processing liquid, a second processing liquid flow-rate adjuster that adjusts a flow rate of the second processing liquid, and a mixer that mixes the first processing liquid with the second processing liquid.

With the substrate processing apparatus according to item 7, the first processing liquid is supplied to the discharger, the second processing liquid is supplied to the discharger, and the first processing liquid and the second processing liquid are mixed. Therefore, the processing liquid in which the first processing liquid and the second processing liquid are mixed is discharged from the discharger. The flow rate of the first processing liquid is adjusted, and the flow rate of the second processing liquid is adjusted. In a case in which the first processing liquid and the second processing liquid have different temperatures or different concentrations, the temperature or the concentration of the processing liquid can be easily adjusted. Further, in a case in which the processing liquid is a liquid in which the first processing liquid and the second processing liquid are mixed, the temperature of the processing liquid or the concentration of the first processing liquid in the processing liquid can be easily adjusted.

(Item 8) The substrate processing apparatus according to item 7, wherein the first processing liquid and the second processing liquid are liquids of a same type and have different temperatures.

With the substrate processing apparatus according to item 8, because the first processing liquid and the second processing liquid have different temperatures, the temperature of the processing liquid can be easily regulated.

(Item 9) The substrate processing apparatus according to item 7, wherein the first processing liquid is a liquid different from the second processing liquid.

With the substrate processing apparatus according to item 9, because the first processing liquid and the second processing liquid are different liquids, the concentration of the first processing liquid in the processing liquid can be easily adjusted.

(Item 10) The substrate processing apparatus according to any one of items 1 to 9, further includes a processing condition acquirer that acquires the processing condition determined using an inference model, with the inference model inferring the processing condition, wherein the inference model is generated by executing machine learning using training data in which the processing condition according to which the substrate processing apparatus has processed the film is used as a target variable, and a first processing amount indicating a difference between film thicknesses obtained before and after the film formed on the substrate is processed by the substrate processing apparatus is used as an explanatory variable.

With the substrate processing apparatus according to item 10, because the inference model is used, the processing condition can be easily determined.

(Item 11) The substrate processing apparatus according to item 10, may further include a processing amount determiner that determines, based on a thickness of the film formed on the substrate before the film is processed, a second processing amount for processing the film, wherein the processing condition acquirer may acquire the processing condition inferred by the inference model to which the second processing amount is provided.

With the substrate processing apparatus according to item 11, the second processing amount is determined by the processing amount determiner, and the processing condition that causes the processing amount in the film process to be the second processing amount is inferred by the inference model. This enables acquisition of the appropriate processing condition according to the thickness of the film formed on the substrate before the process.

(Item 12) A substrate processing apparatus according to another aspect of the present invention includes a rotation driver that rotates a substrate while holding the substrate, a discharger that discharges a processing liquid, a processing liquid supplier that supplies the processing liquid to the discharger, and a discharge driver that moves the discharger to positions above a plurality of different positions on the substrate held by the rotation driver, the plurality of different positions being arranged in a radial direction of the substrate, wherein the processing liquid supplier causes a flow rate of the processing liquid in a case in which the discharger is located above a peripheral area located within a predetermined distance from a periphery of the substrate to be lower than a flow rate of the processing liquid in a case in which the discharger is located above an area other than the peripheral area.

With the substrate processing apparatus according to item 12, because the flow rate of the processing liquid supplied to the peripheral area is lower than those of the processing liquid supplied to the other areas, an area to which the processing liquid spreads on the substrate after being supplied to the peripheral area of the substrate can be relatively small. This suppresses outward splashing, caused by the rotation of the substrate, of the processing liquid that has been supplied to the peripheral area. As a result, it is possible to provide the substrate processing apparatus capable of reducing the consumption of the processing liquid.

(Item 13) The substrate processing apparatus according to item 12, wherein a moving range in which the discharge driver moves the discharger may be defined by a flow rate of the processing liquid supplied by the processing liquid supplier.

With the substrate processing apparatus according to item 13, the moving range in which the discharge driver moves the discharger is defined by the flow rate of the processing liquid. In this case, when the processing liquid that has been discharged from the discharger impinges on the substrate, the processing liquid spreads from the position of impingement to the surrounding area. The lower the flow rate, the smaller an amount of spreading of the processing liquid. When an amount of spreading of the processing liquid is reduced, the position at which the processing liquid impinges on the substrate can be brought closer to the outside of the substrate. Therefore, the film can be efficiently processed.

(Item 14) The substrate processing apparatus according to item 12 or 13, wherein the discharge driver causes a moving speed of the discharger to be zero for a predetermined period of time for any one of the plurality of positions.

With the substrate processing apparatus according to item 14, because the movement of the discharger is stopped above any one of the plurality of positions, an amount of the processing liquid supplied to the position above which the discharger is stopped can be increased. Thus, the processing amount in the film process can be partially varied.

(Item 15) The substrate processing apparatus according to any one of items 12 to 14, wherein the discharge driver may reverse a moving direction of the discharger at least once.

With the substrate processing apparatus according to item 15, because the direction in which the discharger moves is reversed, the processing liquid can be supplied to a plurality of positions multiple times.

(Item 16) The substrate processing apparatus according to any one of items 12 to 15, wherein the rotation driver rotates the substrate at different rotation speeds for the plurality of positions.

With the substrate processing apparatus according to item 16, the substrate is rotated at the different rotation speeds for the plurality of positions. This can facilitate adjustment of an amount of processing liquid to be supplied per unit area to different positions arranged in the radial direction of the substrate.

(Item 17) The substrate processing apparatus according to any one of items 12 to 16, wherein the rotation driver may cause a rotation speed of the substrate in a case in which the discharger is located above a peripheral area to be lower than a rotation speed of the substrate in a case in which the discharger is located above an area other than the peripheral area.

With the substrate processing apparatus according to item 17, when the discharger is located above the peripheral area, the rotation speed of the substrate is low. This suppresses splashing, outwardly of the substrate, of the processing liquid that has been supplied to the substrate.

(Item 18) A substrate processing method according to another aspect of the present invention is executed by a substrate processing apparatus, with the substrate processing apparatus processing a film by supplying a processing liquid to a substrate on which the film is formed, wherein the substrate processing apparatus includes a rotation driver that rotates the substrate while holding the substrate, and a discharger that discharges the processing liquid, and the substrate processing method includes a processing liquid supply step of supplying the processing liquid to the discharger in accordance with a moving condition defining a moving speed of the discharger for each of the plurality of positions, and a discharge driving step of moving, in accordance with a flow-rate condition defining a flow rate of the processing liquid supplied to the discharger for each of the plurality of positions, the discharger to positions above a plurality of different positions on the substrate held by the rotation driver, with the plurality of different positions being arranged in a radial direction of the substrate.

With the substrate processing method according to item 18, it is possible to provide the substrate processing method with which the consumption of the processing liquid for processing the film formed on the substrate can be reduced.

(Item 19) A substrate processing method according to another aspect of the present invention is executed by a substrate processing apparatus, with the substrate processing apparatus processing a film by supplying a processing liquid to a substrate on which the film is formed, wherein the substrate processing apparatus includes a rotation driver that rotates the substrate while rotating the substrate, and a discharger that discharges the processing liquid, the substrate processing method includes a processing liquid supply step of supplying the processing liquid to the discharger, a discharge driving step of moving the discharger to positions above a plurality of different positions on the substrate held by the rotation driver, with the plurality of different positions being arranged in a radial direction of the substrate, and the processing liquid supply step includes causing a flow rate of the processing liquid in a case in which the discharger is located above a peripheral area located within a predetermined distance from a periphery of the substrate to be lower than a flow rate of the processing liquid in a case in which the discharger is located above an area other than the peripheral area.

With the substrate processing method according to item 19, it is possible to provide the substrate processing method with which the consumption of the processing liquid for processing the film formed on the substrate can be reduced.

(Item 20) A substrate processing program according to another aspect of the present invention is executed by a computer that controls a substrate processing apparatus, with the substrate processing apparatus processing a film by supplying a processing liquid to a substrate on which the film is formed, wherein the substrate processing apparatus includes a rotation driver that rotates the substrate while rotating the substrate, and a discharger that discharges the processing liquid, and the substrate processing program causes the computer to execute a processing liquid supply step of supplying the processing liquid to the discharger in accordance with a moving condition defining a moving speed of the discharger for each of the plurality of positions, and a discharge driving step of moving, in accordance with a flow-rate condition defining a flow rate of the processing liquid supplied to the discharger for each of the plurality of positions, the discharger to positions above a plurality of different positions on the substrate held by the rotation driver, with the plurality of different positions being arranged in a radial direction of the substrate.

With the substrate processing method according to item 20, it is possible to provide the substrate processing program that can reduce the consumption of the processing liquid for processing the film formed on the substrate.

(Item 21) A substrate processing program according to another aspect of the present invention is executed by a computer that controls a substrate processing apparatus, with the substrate processing apparatus processing a film by supplying a processing liquid to a substrate on which the film is formed, wherein the substrate processing apparatus includes a rotation driver that rotates the substrate while holding the substrate, and a discharger that discharges the processing liquid, the substrate processing program causes the computer to execute a processing liquid supply step of supplying the processing liquid to the discharger, and a discharge driving step of moving the discharger to positions above a plurality of different positions on the substrate held by the rotation driver, with the plurality of different positions being arranged in a radial direction of the substrate, and the processing liquid supply step includes causing a flow rate of the processing liquid in a case in which the discharger is located above a peripheral area located within a predetermined distance from a periphery of the substrate to be lower than a flow rate of the processing liquid in a case in which the discharger is located above an area other than the peripheral area.

With the substrate processing method according to item 21, it is possible to provide the substrate processing program that can reduce the consumption of the processing liquid for processing the film formed on the substrate.

## Claims

1. A substrate processing apparatus that processes a film by supplying a processing liquid to a substrate on which the film is formed, comprising:
a rotation driver that rotates the substrate while holding the substrate;
a discharger that discharges the processing liquid;
a processing liquid supplier that supplies the processing liquid to the discharger;
a discharge driver that moves the discharger to positions above a plurality of different positions on the substrate held by the rotation driver, the plurality of different positions being arranged in a radial direction of the substrate; and
a controller that controls the processing liquid supplier and the discharge driver in accordance with a processing condition, wherein
the processing condition includes
a moving condition that defines a moving speed of the discharger for each of the plurality of positions, and
a flow-rate condition that defines, for each of the plurality of positions, a flow rate of the processing liquid supplied to the discharger.

2. The substrate processing apparatus according to claim 1, wherein
in the flow-rate condition, a flow rate of the processing liquid in a case in which a position of the discharger is above a peripheral area located within a predetermined distance from a periphery of the substrate is defined to be lower than a flow rate of the processing liquid in a case in which the position of the discharger is above an area other than the peripheral area.

3. The substrate processing apparatus according to claim 1, wherein
the processing condition further includes a rotation condition in which a rotation speed at which the substrate is rotated is defined for each of the plurality of positions.

4. The substrate processing apparatus according to any one of claims 1 to 3, wherein
the processing condition further includes a temperature condition relating to a temperature, for each of the plurality of positions, of the processing liquid discharged from the discharger to the substrate, and
the controller controls the processing liquid supplier to regulate a temperature of the processing liquid discharged from the discharger to the substrate.

5. The substrate processing apparatus according to claim 4, wherein
the processing liquid supplier includes
a supply pipe that supplies the processing liquid to the discharger, and
a heater that is provided in the supply pipe and heats the processing liquid.

6. The substrate processing apparatus according to any one of claims 1 to 3, wherein
the processing condition further includes a mixing ratio condition relating to a mixing ratio, for each of the plurality of positions, of the processing liquid discharged from the discharger to the substrate, and
the controller controls the processing liquid supplier to adjust the mixing ratio of the processing liquid discharged from the discharger to the substrate.

7. The substrate processing apparatus according to claim 6, wherein
the processing liquid supplier includes
a first processing liquid supplier that supplies a first processing liquid to the discharger,
a second processing liquid supplier that supplies a second processing liquid to the discharger,
a first processing liquid flow-rate adjuster that adjusts a flow rate of the first processing liquid,
a second processing liquid flow-rate adjuster that adjusts a flow rate of the second processing liquid, and
a mixer that mixes the first processing liquid with the second processing liquid.

8. The substrate processing apparatus according to claim 7, wherein
the first processing liquid and the second processing liquid are liquids of a same type and have different temperatures.

9. The substrate processing apparatus according to claim 7, wherein
the first processing liquid is a liquid different from the second processing liquid.

10. The substrate processing apparatus according to any one of claims 1 to 9, further comprising a processing condition acquirer that acquires the processing condition determined using an inference model, the inference model inferring the processing condition, wherein
the inference model is generated by executing machine learning using training data in which the processing condition according to which the substrate processing apparatus has processed the film is used as a target variable, and a first processing amount indicating a difference between film thicknesses obtained before and after the film formed on the substrate is processed by the substrate processing apparatus is used as an explanatory variable.

11. The substrate processing apparatus according to claim 10, further comprising a processing amount determiner that determines, based on a thickness of the film formed on the substrate before the film is processed, a second processing amount for processing the film, wherein
the processing condition acquirer acquires the processing condition inferred by the inference model to which the second processing amount is provided.

12. A substrate processing apparatus comprising:
a rotation driver that rotates a substrate while holding the substrate;
a discharger that discharges a processing liquid;
a processing liquid supplier that supplies the processing liquid to the discharger;
and
a discharge driver that moves the discharger to positions above a plurality of different positions on the substrate held by the rotation driver, the plurality of different positions being arranged in a radial direction of the substrate, wherein
the processing liquid supplier causes a flow rate of the processing liquid in a case in which the discharger is located above a peripheral area located within a predetermined distance from a periphery of the substrate to be lower than a flow rate of the processing liquid in a case in which the discharger is located above an area other than the peripheral area.

13. The substrate processing apparatus according to claim 12, wherein
a moving range in which the discharge driver moves the discharger is defined by a flow rate of the processing liquid supplied by the processing liquid supplier.

14. The substrate processing apparatus according to claim 12 or 13,
wherein
the discharge driver causes a moving speed of the discharger to be zero for a predetermined period of time for any one of the plurality of positions.

15. The substrate processing apparatus according to any one of claims 12 to 14, wherein
the discharge driver reverses a moving direction of the discharger at least once.

16. The substrate processing apparatus according to any one of claims 12 to 15, wherein
the rotation driver rotates the substrate at different rotation speeds for the plurality of positions.

17. The substrate processing apparatus according to any one of claims 12 to 16, wherein
the rotation driver causes a rotation speed of the substrate in a case in which the discharger is located above a peripheral area to be lower than a rotation speed of the substrate in a case in which the discharger is located above an area other than the peripheral area.

18. A substrate processing method executed by a substrate processing apparatus, the substrate processing apparatus processing a film by supplying a processing liquid to a substrate on which the film is formed, wherein
the substrate processing apparatus includes
a rotation driver that rotates the substrate while holding the substrate, and
a discharger that discharges the processing liquid, and
the substrate processing method includes
a processing liquid supply step of supplying the processing liquid to the discharger in accordance with a moving condition defining a moving speed of the discharger for each of the plurality of positions, and
a discharge driving step of moving, in accordance with a flow-rate condition defining a flow rate of the processing liquid supplied to the discharger for each of the plurality of positions, the discharger to positions above a plurality of different positions on the substrate held by the rotation driver, with the plurality of different positions being arranged in a radial direction of the substrate.

19. A substrate processing method executed by a substrate processing apparatus, the substrate processing apparatus processing a film by supplying a processing liquid to a substrate on which the film is formed, wherein
the substrate processing apparatus includes
a rotation driver that rotates the substrate while rotating the substrate, and
a discharger that discharges the processing liquid,
the substrate processing method includes
a processing liquid supply step of supplying the processing liquid to the discharger,
a discharge driving step of moving the discharger to positions above a plurality of different positions on the substrate held by the rotation driver, with the plurality of different positions being arranged in a radial direction of the substrate, and
the processing liquid supply step includes causing a flow rate of the processing liquid in a case in which the discharger is located above a peripheral area located within a predetermined distance from a periphery of the substrate to be lower than a flow rate of the processing liquid in a case in which the discharger is located above an area other than the peripheral area.

20. A substrate processing program executed by a computer that controls a substrate processing apparatus, the substrate processing apparatus processing a film by supplying a processing liquid to a substrate on which the film is formed, wherein
the substrate processing apparatus includes
a rotation driver that rotates the substrate while rotating the substrate, and
a discharger that discharges the processing liquid, and
the substrate processing program causes the computer to execute
a processing liquid supply step of supplying the processing liquid to the discharger in accordance with a moving condition defining a moving speed of the discharger for each of the plurality of positions, and
a discharge driving step of moving, in accordance with a flow-rate condition defining a flow rate of the processing liquid supplied to the discharger for each of the plurality of positions, the discharger to positions above a plurality of different positions on the substrate held by the rotation driver, with the plurality of different positions being arranged in a radial direction of the substrate.

21. A substrate processing program executed by a computer that controls a substrate processing apparatus, the substrate processing apparatus processing a film by supplying a processing liquid to a substrate on which the film is formed, wherein
the substrate processing apparatus includes
a rotation driver that rotates the substrate while holding the substrate, and
a discharger that discharges the processing liquid,
the substrate processing program causes the computer to execute
a processing liquid supply step of supplying the processing liquid to the discharger, and
a discharge driving step of moving the discharger to positions above a plurality of different positions on the substrate held by the rotation driver, with the plurality of different positions being arranged in a radial direction of the substrate, and
the processing liquid supply step includes causing a flow rate of the processing liquid in a case in which the discharger is located above a peripheral area located within a predetermined distance from a periphery of the substrate to be lower than a flow rate of the processing liquid in a case in which the discharger is located above an area other than the peripheral area.
